# EUROPEAN PATENT APPLICATION

(11) **EP 4 428 783 A1**
(43) Date of publication of application: **11.09.2024**
(21) Application number: 24161982.4
(22) Date of filing: 07.03.2024
(51) Int. Cl.: G06Q 10/06, G06Q 10/101

(54) **COLLABORATIVE WORK SUPPORT PROGRAM, WORK SUPPORT PROGRAM, COLLABORATIVE WORK SUPPORT SYSTEM AND WORK SUPPORT SYSTEM**

(30) Priority: 08.03.2023 JP 2023035244
(71) Applicant: Takasago Thermal Engineering Co., Ltd., Tokyo 160-0022 (JP)
(72) Inventor: KATAYAMA, Kenichiro, Tokyo, 160-0022 (JP); SAITO, Hidenori, Tokyo, 160-0022 (JP)
(74) Representative: Zinkler, Franz

(57) **Abstract**

To make work performed during a life cycle of a building more efficient.

A collaborative work support program includes a plurality of work support programs for supporting a predetermined work relating to construction. A first work support program and a second work support program among the plurality of work support programs respectively cause a first computer and a second computer to execute work processing based on one BIM model and store electronic data during the work processing. The first work support program causes the first computer to output the electronic data to the second computer. The second work support program causes the second computer to specify the electronic data based on one or more parameters in the one BIM model of the electronic data input from the first computer.

## Description

### TECHNICAL FIELD

The present invention relates to a collaborative work support program, a work support program, a collaborative work support system, and a work support system.

### BACKGROUND ART

Computer Aided Design (CAD), which implements Building Information Modeling (BIM), is used in the architectural design. The use of BIM for buildings enables efficient work performance at each phase of the building lifecycle, including the design phase, the construction phase, and the operation and management phase.

For example, Patent Document 1 discloses a design support apparatus that creates CAD drawings, based on BIM models of buildings. The design support apparatus disclosed in Patent Document 1 considers even interference between an operating area of a seismic isolator and other objects in creating CAD drawings of a building having the seismic isolator.

### RELATED ART DOCUMENT

### PATENT DOCUMENT

Patent Document 1: Japanese Unexamined Patent Application Publication No. 2020-201790

### SUMMARY OF THE INVENTION

### PROBLEMS TO BE SOLVED BY THE INVENTION

However, in the related art technique, the BIM appears not to be sufficiently utilized during the lifecycle of a building. For example, there are individual software programs for the processes from order reception and estimation to construction management and operation management, but the utilization of the software programs in collaboration with each other is not sufficiently achieved.

In view of the above technical issues, an object of one aspect of the present invention is to provide a work support program that makes work performed during the lifecycle of a building more efficient.

### MEANS FOR SOLVING THE PROBLEMS

According to one aspect of the present invention, a collaborative work support program includes a plurality of work support programs for supporting a predetermined work relating to construction. A first work support program and a second work support program among the plurality of work support programs respectively cause a first computer and a second computer to execute work processing based on one BIM model and store electronic data during the work processing. The first work support program causes the first computer to output the electronic data to the second computer. The second work support program causes the second computer to specify the electronic data based on one or more parameters in the one BIM model of the electronic data input from the first computer.

### EFFECTS OF THE INVENTION

According to an aspect of an embodiment of the present invention, it is possible to provide a collaborative work support program that makes work performed during the lifecycle of a building more efficient.

### BRIEF DESCRIPTION OF THE DRAWINGS

FIG. 1 is a block diagram illustrating an example of an overall configuration of a collaborative work support system.
FIG. 2 is a block diagram illustrating an example of a hardware configuration of a computer.
FIG. 3 is a block diagram illustrating an example of a data flow of a collaborative work support system.
FIG. 4 is a block diagram illustrating an example of a functional configuration of an automatic design system.
FIG. 5 is a diagram illustrating an example of a design screen.
FIG. 6 is a diagram illustrating an example of a design screen.
FIG. 7 is a diagram illustrating an example of a design screen.
FIG. 8 is a block diagram illustrating an example of a functional configuration of an estimate support system.
FIG. 9 is a diagram illustrating an example of an estimate screen.
FIG. 10 is a diagram illustrating an example of an estimate screen.
FIG. 11 is a diagram illustrating an example of an estimate screen.
FIG. 12 is a diagram illustrating an example of an estimate screen.
FIG. 13 is a block diagram illustrating an example of a functional configuration of an inquiry system.
FIG. 14 is a diagram illustrating an example of an inquiry screen.
FIG. 15 is a block diagram illustrating an example of a functional configuration of an initial cost examination system.
FIG. 16 is a diagram illustrating an example of an initial cost management screen.
FIG. 17 is a block diagram illustrating an example of a functional configuration of a construction drawing creation system.
FIG. 18 is a diagram illustrating an example of a construction drawing creation screen.
FIG. 19 is a diagram illustrating an example of a construction drawing creation screen.
FIG. 20 is a diagram illustrating an example of a construction drawing creation screen.
FIG. 21 is a diagram illustrating an example of a construction drawing creation screen.
FIG. 22 is a diagram illustrating an example of a construction drawing creation screen.
FIG. 23 is a block diagram illustrating an example of a functional configuration of a process management system.
FIG. 24 is a diagram illustrating an example of a process management screen.
FIG. 25 is a block diagram illustrating an example of a functional configuration of a progress management system.
FIG. 26 is a view illustrating an example of a progress management screen.
FIG. 27 is a diagram illustrating an example of a progress management screen.
FIG. 28 is a diagram illustrating an example of a progress management screen.
FIG. 29 is a block diagram illustrating an example of a functional configuration of a quality control system.
FIG. 30 is a diagram illustrating an example of a quality control screen.
FIG. 31 is a diagram illustrating an example of a quality control screen.
FIG. 32 is a diagram illustrating an example of a quality control screen.
FIG. 33 is a diagram illustrating an example of collaboration among a process management system, a progress management system, and a quality control system.
FIG. 34 is a block diagram illustrating an example of a functional configuration of an operation management system.
FIG. 35 is a block diagram illustrating an example of a functional configuration of an information sharing system.
FIG. 36 is a flowchart illustrating an example of a collaborative work support method.

### EMBODIMENTS OF THE INVENTION

Hereinafter, embodiments of the present invention will be described with reference to the accompanying drawings. In the present specification and drawings, components having substantially the same functional configuration are denoted by the same reference numerals, and redundant description thereof will be omitted.

### [Embodiments]

An embodiment of the present invention relates to a collaborative work support system (hereinafter, also referred to as a "design support system") for supporting a design of a building. The collaborative work support system according to the present embodiment includes a plurality of work support systems each supporting work performed during the lifecycle of a building. The collaborative work support system includes an information sharing system for providing shared information commonly used in each work to the plurality of work support systems.

Each work support system executes processing for supporting a predetermined work based on a BIM model that holds information generated in a previous process. The BIM model is a model having a plurality of objects including attribute information. The BIM model in the present embodiment is a three dimensional model, but a substantially two dimensional model may be generated or used by not including information on height.

In the BIM model of a building, the objects include, for example, the structure of the building, such as beams, columns, walls, floors, and ceilings, or facilities such as air conditioning, electrical, sanitary, piping, and wiring. In the BIM model of a building, attribute information is, for example, information about the shapes, material, dimensions, and installation location of each object. The attribute information in the present embodiment further includes information used in the design phase such as product information and cost information, and information used in the construction phase such as process management information, progress management information, and quality control information.

Each work support system receives, from the work support system supporting the previous process, a BIM model or information generated based on the BIM model in which information generated in the previous process is registered in the attribute information on each object, and executes a predetermined work, based on the BIM model or the generated information. Each work support system registers information generated in the predetermined work in the attribute information on each object to generate a BIM model used by the work support system for supporting a post-process.

In the related art, a BIM model of a building is created in the design phase and is used in the operation management phase in order to be used in each work during the lifecycle of the building. However, in the related art BIM model, only attribute information on each object is registered, and electronic data such as an image is not registered. For example, the progress management work and the quality control work in the construction phase are similar in that they both manage the state of the construction part. Therefore, when the progress management work and the quality control work can share the photograph of the construction part or the periphery thereof via the BIM model, each work can be executed with high accuracy and efficiency.

The collaborative work support system according to the present embodiment aims to expand the range of use of the BIM model during the lifecycle of a building and to make each work during the lifecycle of a building more efficient.

### <Overall Configuration of Collaborative Work Support System>

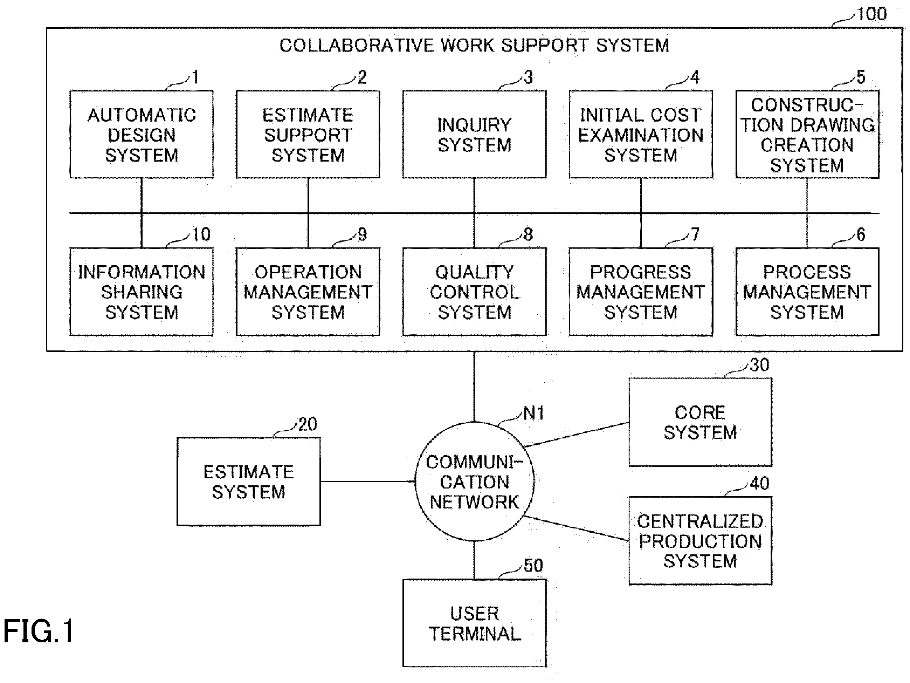

The overall configuration of the collaborative work support system according to the present embodiment will be described with reference to FIG. 1. FIG. 1 is a block diagram illustrating an example of the overall configuration of a collaborative work support system according to the present embodiment.

As illustrated in FIG. 1, the collaborative work support system 100 according to the present embodiment includes an automatic design system 1, an estimate support system 2, an inquiry system 3, an initial cost examination system 4, a construction drawing creation system 5, a process management system 6, a progress management system 7, a quality control system 8, an operation management system 9, and an information sharing system 10.

The collaborative work support system 100 according to the present embodiment is configured to perform data transmission with an estimate system 20, a core system 30, a centralized production system 40, and a user terminal 50 via a communication network N1 such as a local area network (LAN) or the Internet.

The automatic design system 1, the estimate support system 2, the inquiry system 3, the initial cost examination system 4, the construction drawing creation system 5, the process management system 6, the progress management system 7, the quality control system 8, and the operation management system 9 are examples of a work support system. In particular, the estimate support system 2 and the automatic design system 1 are examples of a first work support system. The inquiry system 3, the initial cost examination system 4, the construction drawing creation system 5, the process management system 6, the progress management system 7, the quality control system 8, and the operation management system 9 are examples of a second work support system.

The automatic design system 1 is an information processing apparatus such as a personal computer, a workstation, or a server that supports a design work. The design work is work for designing a building based on the specification information on the building. The design work includes preparation of design documents, preparation of materials to be submitted to the client or general contractor, etc., and verification of deliverables by subcontractors.

In the present embodiment, the automatic design system 1 has a function of generating a BIM model indicating a design drawing based on a BIM model relating to a previously constructed building. The automatic design system 1 has a function of automatically creating a design statement based on the BIM model. The automatic design system 1 also has a capability of automatically calculating the amount of greenhouse gas (CO₂) emissions based on the BIM model. Furthermore, the automatic design system 1 has a function of automatically selecting and arranging facility devices to be installed in a building based on the BIM model. The facility devices include, for example, air conditioning facilities, electric facilities, and sanitary facilities.

The estimate support system 2 is an information processing apparatus such as a personal computer, a workstation, or a server that supports an estimate work. The estimate work is work for creating an initial estimate of the construction cost based on the design information on the building. The initial estimate includes the types of materials, equipment, and the like used for building construction, and the approximate prices of materials, work, management, and the like required for building construction.

In the present embodiment, the estimate support system 2 generates a BIM model indicating the structure and facilities of a building based on the design information and the special specification of the building. The estimate support system 2 has a function of creating integrated information indicating an initial estimate based on the BIM model. Furthermore, the estimate support system 2 has a function of creating a three dimensional BIM model not having information on a height based on a two dimensional CAD drawing. The estimate support system 2 has a function of recognizing specification information described in a paper special specification by optical character recognition (OCR) or the like and reflecting the specification information in the BIM model.

The inquiry system 3 is an information processing apparatus such as a personal computer, a workstation, or a server that supports inquiry work. The inquiry work is work for collecting proposal information on facility devices to be installed in a building from device vendors or the like and determining product information and cost information relating to the devices. The inquiry work includes contact with the device vendors, reception of proposal information on the facility devices, comparison and evaluation of the proposal information, and the like.

In the present embodiment, the inquiry system 3 has a function of acquiring vendor information from the core system 30 and transmitting a proposal request including integrated information to the device vendors or the like. The proposal request is written in a unified format, and the proposal information input by the inquiry system 3 is also generated in a unified format. The inquiry system 3 has a function of evaluating the validity of proposal information by comparing proposal information received from device vendors or the like with product information and cost information in previous construction projects.

The initial cost examination system 4 is an information processing apparatus such as a personal computer, a workstation, or a server that supports an initial cost examination work. The initial cost examination work is work for managing an initial cost for integrating the construction cost of a building. The initial cost examination work includes calculating a unified initial cost based on costs in previous construction projects. The unified initial cost includes an initial cost relating to material costs of materials or facility devices, and a cost relating to labor costs for work or management.

In the present embodiment, the initial cost examination system 4 has a function of calculating a unified initial cost from the product information and the cost information determined by the inquiry system 3 in collaboration with the estimate system 20. The initial cost examination system 4 has a function of creating integrated information indicating a detailed estimate based on the BIM model.

The construction drawing creation system 5 is an information processing apparatus such as a personal computer, a workstation, or a server that supports a construction drawing creation work. The construction drawing creation work is work for creating a construction drawing from a design drawing.

In the present embodiment, the construction drawing creation system 5 has a function of generating a BIM model indicating a construction drawing based on the BIM model generated by the automatic design system 1 and the BIM model generated by the initial cost examination system 4. The BIM model generated by the initial cost examination system 4 is a BIM model that does not have information on height, and the BIM model indicating the construction drawing is a BIM model that has information on height. The construction drawing creation system 5 has an automatic routing function of optimizing the routes of various pipes. Further, the construction drawing creation system 5 has a unit function of optimizing the position at which each facility device is installed in the building.

The process management system 6 is an information processing apparatus such as a personal computer, a workstation, or a server that supports a process management work. The process management work is work for managing each process for constructing a building based on schedule information indicating an order status, delivery date information, and the like of materials, facility devices, and the like used for construction.

In the present embodiment, the process management system 6 has a function of generating a BIM model in which process information is registered in attribute information on each object, based on the BIM model generated by the construction drawing creation system 5. The process management system 6 has a function of generating a BIM model based on the schedule information acquired from the centralized production system 40. The process management system 6 also generates a process table based on the BIM model and displays the process table on a personal digital assistant such as a smartphone or a tablet computer.

The progress management system 7 is an information processing apparatus such as a personal computer, a workstation, or a server that supports progress management work. The progress management work is work for managing a progress status of each process in a construction project for constructing a building.

In the present embodiment, the progress management system 7 has a function of reflecting the progress management information in the BIM model generated by the construction drawing creation system 5. The progress management information includes information for identifying a panoramic photograph (360-degree image) taken in the building and indicated matter. The progress management system 7 has a function of generating a virtual space of the building based on the BIM model, displaying the virtual space and a panoramic photograph in a comparable manner, and enabling the progress status of each process to be checked from a remote location.

The information for identifying the panoramic photograph is, for example, a uniform resource locator (URL) indicating an electronic location of electronic data in which the panoramic photograph is recorded. The electronic file in which the panoramic photograph is recorded may be stored in a storage unit such as an HDD 504 of the progress management system 7 or a storage unit such as an HDD 504 of the information sharing system 10.

The quality control system 8 is an information processing apparatus such as a personal computer, a workstation, or a server that supports quality control work. The quality control work involves tracking the status of response to tasks (indicated matter) that occur in each process and managing the quality of the building.

In the present embodiment, the quality control system 8 has a function of reflecting quality control information in the BIM model generated by the construction drawing creation system 5. The quality control information includes a construction photograph taken at the construction site, blackboard information indicating completion of construction, an inspection list indicating inspection items, and the like. The quality control system 8 has a function of setting inspection points in the BIM model and registering quality control information at each inspection point. Further, the quality control system 8 has a function of displaying progress management information (e.g., a panoramic photograph and indicated matter) and quality control information (e.g., a construction photograph and blackboard information) registered at each inspection point so as to be compared with each other based on the BIM model, and enabling the quality of the building to be checked from a remote place.

The operation management system 9 is an information processing apparatus such as a personal computer, a workstation, or a server that supports operation management work. The operation management work is work for maintaining and managing a building in operation. The operation management work includes monitoring, repair, replacement, and the like of the structure and facilities of the building.

In the present embodiment, the operation management system 9 has a function of reflecting operation management information in the BIM model generated by the construction drawing creation system 5. The operation management information includes identification information for identifying operation data, inspection data, maintenance data, and the like of the facility devices. The operation data is data indicating operation states that are constantly output by the facility devices. The inspection data is data indicating the results of inspection of the structure, facilities, and the like of a building, which is periodically performed. The maintenance data is data indicating a history of repair, replacement, and the like of the structure, facilities, and the like of the building.

The information for identifying the operation data, the inspection data, or the maintenance data is, for example, a URL indicating an electronic location of electronic data in which each data is recorded. The electronic data in which the operation data, the inspection data, or the maintenance data is recorded may be stored in a storage unit such as an HDD 504 of the operation management system 9 or a storage unit such as an HDD 504 of the information sharing system 10.

The information sharing system 10 is an information processing apparatus such as a personal computer, a workstation, or a server that provides shared information shared among the work support systems included in the collaborative work support system 100 to each of the work support systems. The shared information includes a BIM model generated by the operation management system 9 and external information acquired from an external data source. The external information includes previous and current commodity price information (material prices, labor costs, etc.), previous and current climate information, and the like. The information sharing system 10 transmits requested shared information to the work support system in response to a request from the work support system.

The user terminal 50 is an information processing terminal such as a personal computer, a smartphone, or a tablet computer operated by a user who uses the collaborative work support system 100. The user terminal 50 connects to a work support system included in the collaborative work support system 100 in response to a user's operation, and requests processing relating to a predetermined work via a screen provided by the work support system. The user terminal 50 receives a result of processing relating to a predetermined work from the work support system and outputs the result to the user.

The user terminal 50 may be a single information processing terminal connected to all the work support systems. The user terminal 50 may be a plurality of information processing terminals connected to the respective work support systems. When the collaborative work support system 100 includes a plurality of user terminals 50, the user terminals 50 may be disposed in one facility or in different facilities. For example, when companies in charge of the respective works are different, the user terminals 50 may be arranged in the companies corresponding to the respective works.

The overall configuration of the collaborative work support system 100 illustrated in FIG. 1 is an example, and various system configuration examples are possible according to the application and purpose. For example, the collaborative work support system 100 may include one or more of the automatic design system 1, the estimate support system 2, the inquiry system 3, the initial cost examination system 4, the construction drawing creation system 5, the process management system 6, the progress management system 7, the quality control system 8, the operation management system 9, and the information sharing system 10.

For example, the automatic design system 1, the estimate support system 2, the inquiry system 3, the initial cost examination system 4, the construction drawing creation system 5, the process management system 6, the progress management system 7, the quality control system 8, the operation management system 9, or the information sharing system 10 may be implemented by a plurality of computers or may be implemented as a service of cloud computing.

For example, the collaborative work support system 100 may include a stand-alone work support system having the functions of both the automatic design system 1 and the construction drawing creation system 5, or the functions of the process management system 6, the progress management system 7, and the quality control system 8. The classification of the devices such as the automatic design system 1, the estimate support system 2, the inquiry system 3, the initial cost examination system 4, the construction drawing creation system 5, the process management system 6, the progress management system 7, the quality control system 8, the operation management system 9, and the information sharing system 10 illustrated in FIG. 1 is an example.

### <Hardware Configuration of Collaborative Work Support System>

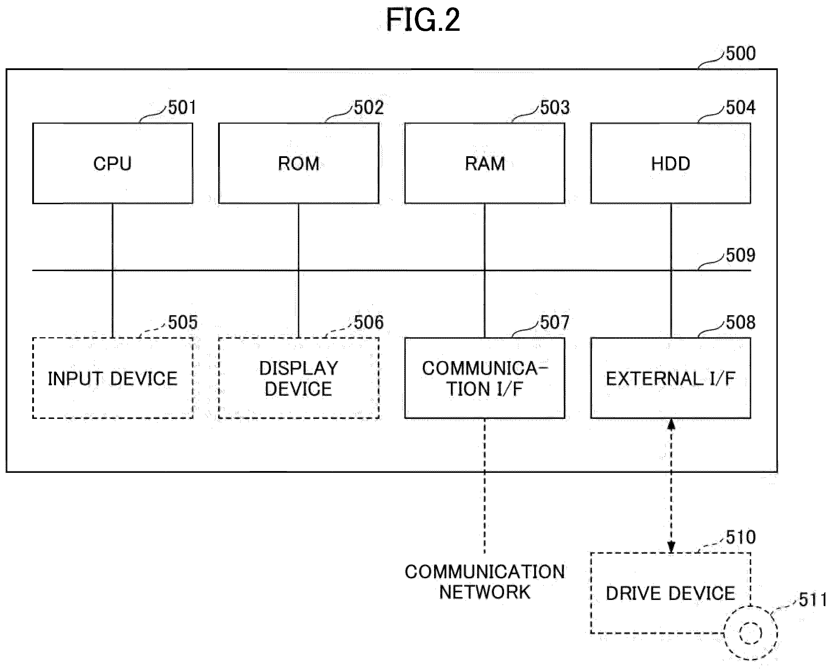

A hardware configuration of each device included in the collaborative work support system 100 according to the present embodiment will be described with reference to FIG. 2.

### «Hardware Configuration of Computer»

The automatic design system 1, the estimate support system 2, the inquiry system 3, the initial cost examination system 4, the construction drawing creation system 5, the process management system 6, the progress management system 7, the quality control system 8, the operation management system 9, and the information sharing system 10 in the present embodiment are implemented by, for example, a computer. FIG. 2 is a block diagram illustrating an example of a hardware configuration of a computer according to the present exemplary embodiment.

As illustrated in FIG. 2, a computer 500 according to the present embodiment includes a central processing unit (CPU) 501, a read only memory (ROM) 502, a random access memory (RAM) 503, a hard disk drive (HDD) 504, an input device 505, a display device 506, a communication interface (I/F) 507, and an external I/F 508. CPU 501, ROM 502 and RAM 503 form so-called computers. The hardware components of the computer 500 are connected to each other via a bus line 509. The input device 505 and the display device 506 may be used by being connected to an external I/F 508.

The CPU 501 is an arithmetic device that reads a program from a storage unit such as ROM 502 or HDD 504 onto the RAM 503 and executes processing to control the entire computer 500 and implement functions of the computer 500. The computer 500 may include a graphics processing unit (GPU) in addition to the CPU 501 or instead of the CPU 501.

The ROM 502 is an example of a non-volatile semiconductor memory (storage unit) that can retain programs and data even when the power is turned off. The ROM 502 functions as a main storage unit for storing various programs and data necessary for the HDD 504 to execute various programs installed in the CPU 501. In particular, the ROM 502 stores boot programs such as BIOS (basic input/output system) and EFI (Extensible Firmware Interface) to be executed at the time of starting the computer 500, and OS (Operating System) settings and network settings.

The RAM 503 is an example of a volatile semiconductor memory (storage unit) from which programs and data are erased when the power is turned off. The RAM 503 is, for example, a dynamic random access memory (DRAM), a static random access memory (SRAM), or the like. The RAM 503 provides a work area that is developed when various programs installed in the HDD 504 are executed by the CPU 501.

The HDD 504 is an example of a non-volatile storage unit. The programs and data stored in the HDD 504 include an OS which is basic software for controlling the entire computer 500, applications for providing various functions on the OS, and the like. The computer 500 may use a storage media (e.g., a solid state drive (SSD)) using a flash memory as a storage unit instead of the HDD 504.

The input device 505 is a touch panel, operation keys and buttons, a keyboard, a mouse, a microphone, and the like used by a user to input various signals.

The display device 506 is configured by a display such as a liquid crystal or organic electro-luminescence (EL) display that displays a screen, a speaker that outputs sound data such as voice, and the like.

The communication I/F 507 is an interface that is connected to a communication network and allows the computer 500 to perform data transmission.

The external I/F 508 is an interface with an external device. The external device includes a drive device 510.

The drive device 510 is a device for setting a recording medium 511. The recording medium 511 includes media that optically, electrically, or magnetically record information, such as a CD-ROM, a flexible disk, and a magneto-optical disk. The recording medium 511 may include media that electrically record information, such as a ROM and a flash memory. The computer 500 can read and/or write data from/to the recording medium 511 via the external I/F 508.

The various programs to be installed in the HDD 504 are installed by, for example, setting the distributed recording medium 511 in the drive device 510 connected to the external I/F 508 and reading the various programs recorded in the recording medium 511 by the drive device 510. Alternatively, the various programs installed in the HDD 504 may be installed by being downloaded from another network different from the communication network via the communication I/F 507.

### <Data Flow of Collaborative work Support System>

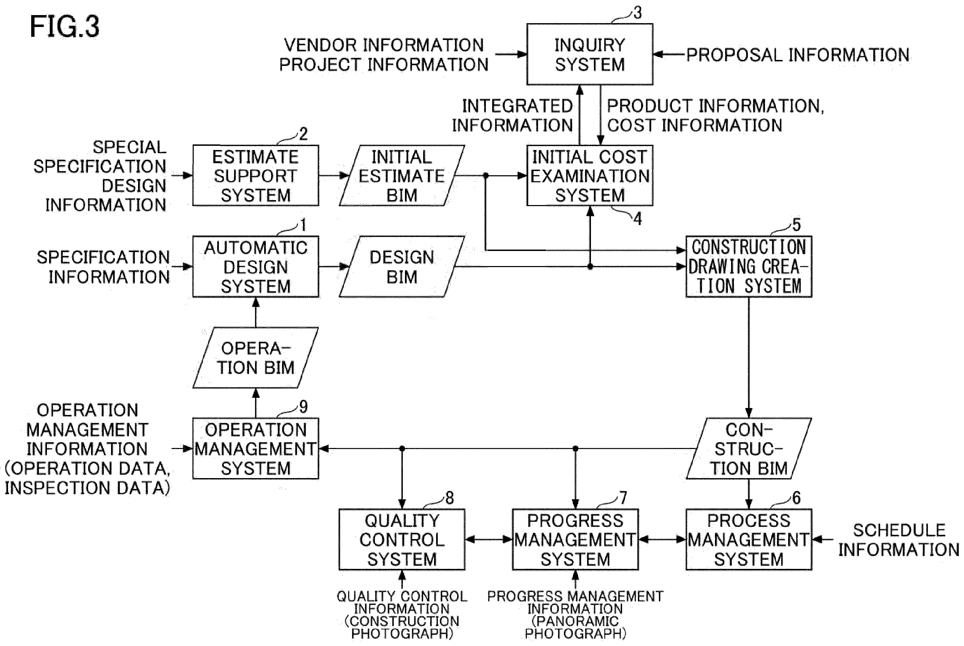

A data flow of the collaborative work support system according to the present embodiment will be described with reference to FIG. 3. FIG. 3 is a block diagram illustrating an example of a data flow of the collaborative work support system 100 according to the present embodiment.

The automatic design system 1 receives specification information on a building from the user terminal 50. The automatic design system 1 generates a BIM model (design BIM) indicating a design drawing of the building based on a BIM model (operation BIM) relating to a previously constructed building and specification information on the building. The operation BIM is generated by the operation management system 9 and stored in the information sharing system 10. The design BIM generated by the automatic design system 1 is transmitted to the initial cost examination system 4 and the construction drawing creation system 5.

The estimate support system 2 receives the design information and the special specification of the building from the user terminal 50. The estimate support system 2 generates a BIM model (initial estimate BIM) indicating the structure and facilities of a building based on operation BIM relating to the previously constructed building, and design information and special specification of the building. The initial estimate BIM generated by the estimate support system 2 is transmitted to the initial cost examination system 4 and the construction drawing creation system 5.

The inquiry system 3 receives the vendor information and the project information from the core system 30. The inquiry system 3 receives the integrated information from the initial cost examination system 4, and transmits a proposal request including the integrated information to the device vendors or the like. The inquiry system 3 generates product information and cost information based on the proposal information received from the device vendors or the like and transmits them to an initial cost examination system 4.

The initial cost examination system 4 generates integrated information based on the initial estimate BIM generated by the estimate support system 2 and transmits it to the inquiry system 3. The initial cost examination system 4 calculates a unified initial cost from the product information and the cost information determined by the inquiry system 3 by collaborating with the estimate system 20.

The construction drawing creation system 5 generates a BIM model (construction BIM) indicating a construction drawing based on the design BIM generated by the automatic design system 1 and the initial estimate BIM generated by the estimate support system 2. The construction BIM generated by the construction drawing creation system 5 is transmitted to the process management system 6, the progress management system 7, the quality control system 8, and the operation management system 9.

The process management system 6 receives schedule information from the centralized production system 40. The process management system 6 registers process information in the construction BIM generated by the construction drawing creation system 5. The construction BIM updated by the process management system 6 is transmitted to the progress management system 7.

The process management system 6 receives construction completion information from the quality control system 8. The construction completion information indicates a construction part where construction has been completed and date and time when construction is completed. When the construction completion information is received, the process management system 6 registers the construction completion information in the construction BIM.

The progress management system 7 receives the progress management information from the user terminal 50. The progress management system 7 registers progress management information in the construction BIM generated by the construction drawing creation system 5.

The progress management system 7 receives construction completion information indicating a construction part where construction has been completed from the quality control system 8. When the progress management system 7 receives the construction completion information, the progress management system 7 registers the construction completion information in the construction BIM.

The quality control system 8 receives the quality control information from the user terminal 50. The quality control system 8 registers quality control information in the construction BIM generated by the construction drawing creation system 5. When there is a construction part where construction has been completed, the quality control system 8 transmits construction completion information to the process management system 6 and the progress management system 7. When construction is completed at all construction sites (that is, when the building is completed), the construction BIM in which the quality control information is registered by the quality control system 8 is transmitted to the operation management system 9.

The operation management system 9 receives operation management information (operation data, inspection data, or maintenance data) from the user terminal 50. The operation management system 9 registers operation management information in the construction BIM relating to the building in operation. The BIM model (operation BIM) in which the operation management information is registered by the operation management system 9 is stored in the information sharing system 10.

### <Functional Configuration of Collaborative work Support System>

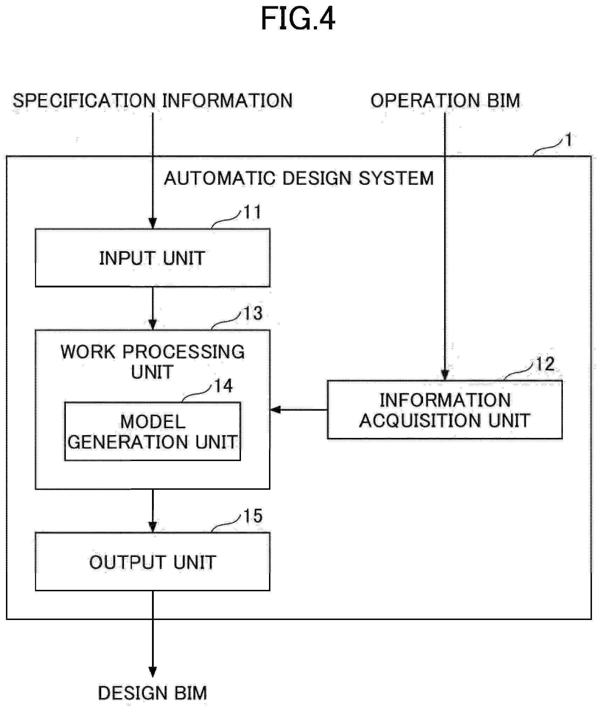

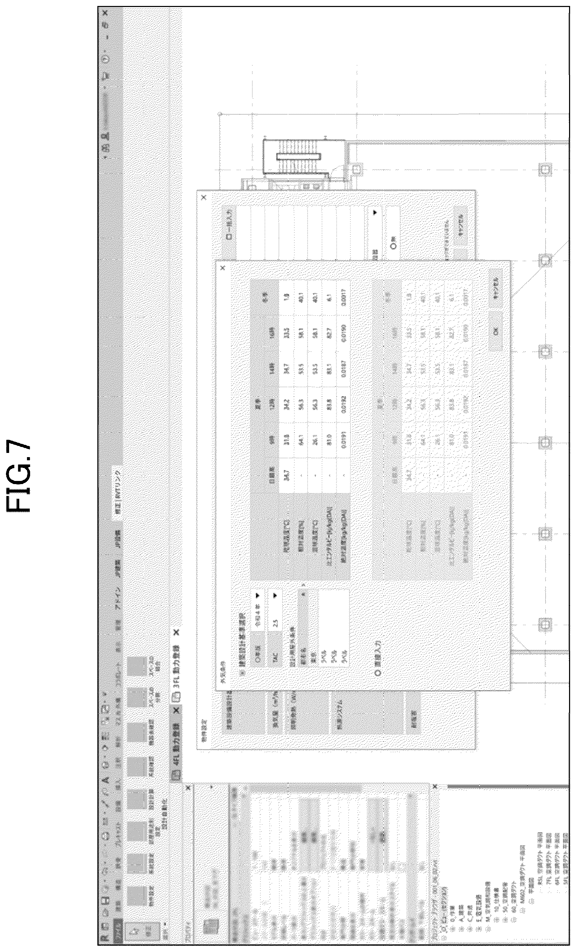

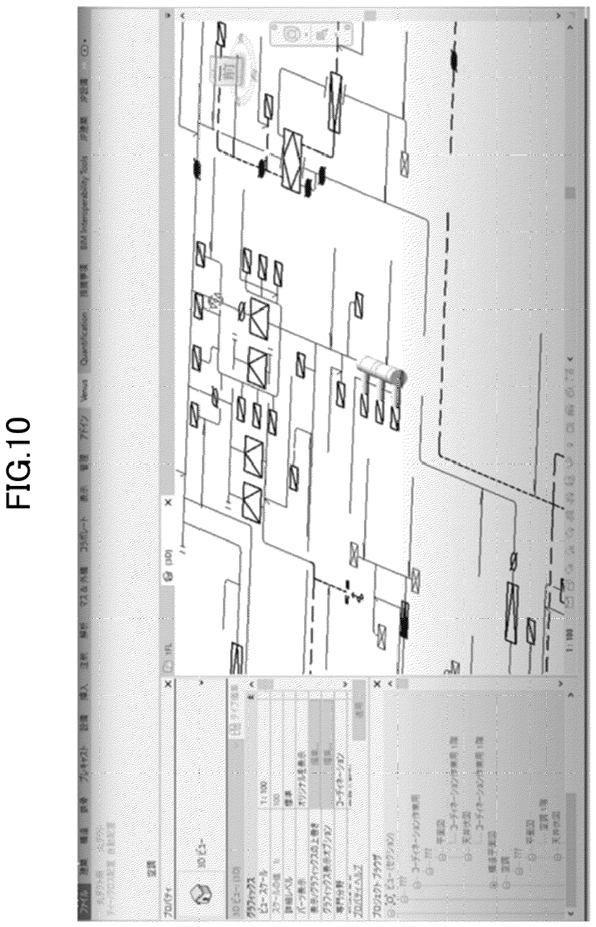

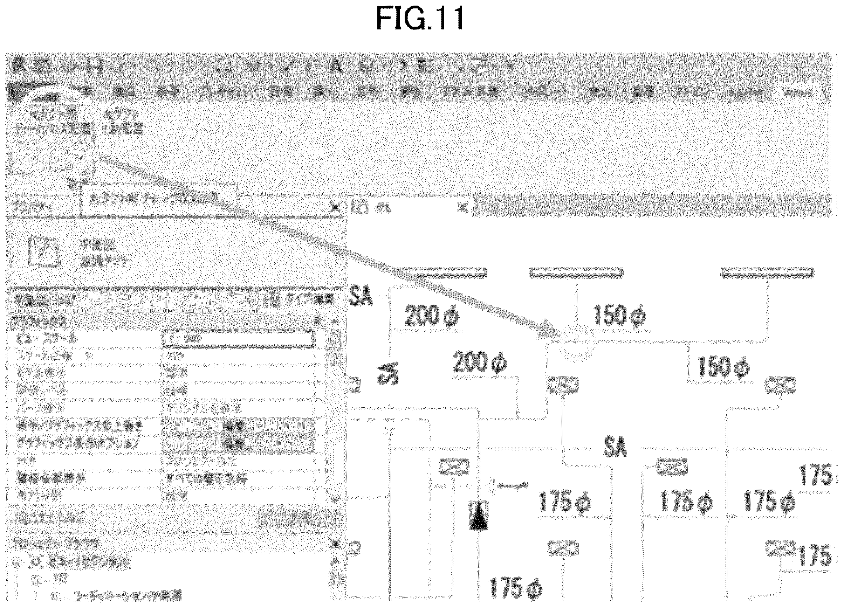

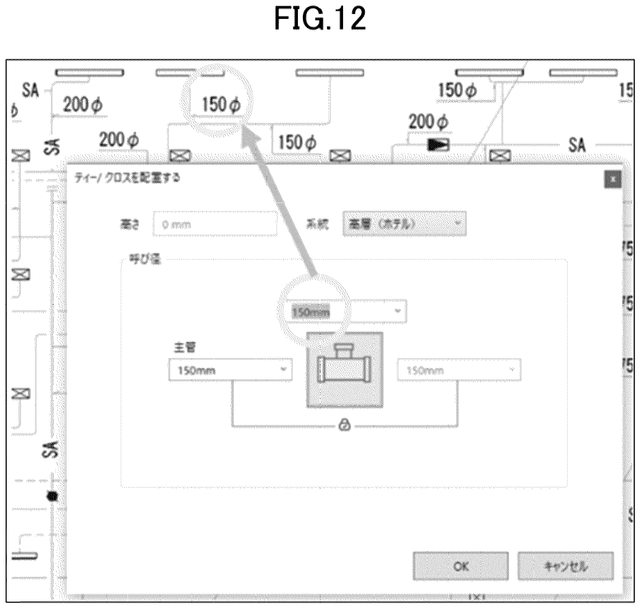

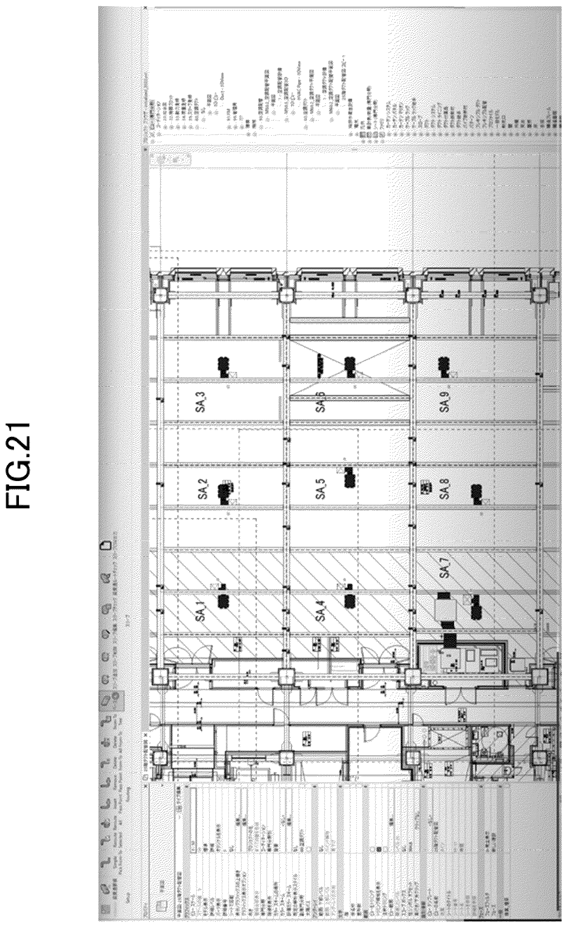

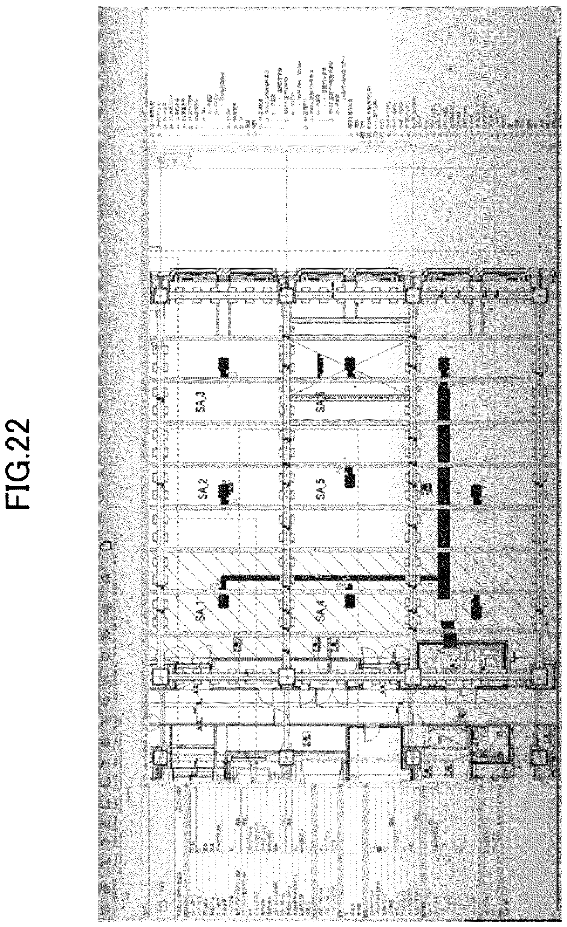

A functional configuration of the collaborative work support system according to the present embodiment will be described with reference to FIGS. 4 to 34.

### «Functional Configuration of Automatic Design System»

FIG. 4 is a block diagram illustrating an example of a functional configuration of the automatic design system 1 in the present embodiment. As illustrated in FIG. 4, the automatic design system 1 in the present embodiment includes an input unit 11, an information acquisition unit 12, a work processing unit 13, a model generation unit 14, and an output unit 15.

The input unit 11, the information acquisition unit 12, the work processing unit 13, the model generation unit 14, and the output unit 15 are implemented by, for example, a process of causing the CPU 501 to execute a program loaded on the RAM 503 from the HDD 504 illustrated in FIG. 2.

The input unit 11 receives an input of specification information on a building. The specification information on the building is data describing specifications to be satisfied by the building requested by a client. The input unit 11 receives specification information from the user terminal 50 to receive input of the specification information.

The information acquisition unit 12 acquires the operation BIM from the information sharing system 10. The operational BIM is a BIM model relating to a previously constructed building. The operation BIM is generated by the operation management system 9 and stored in the information sharing system 10.

The work processing unit 13 displays a design screen for supporting the design work on the user terminal 50. The work processing unit 13 executes processing relating to the design work, in response to a request from the user terminal 50. When the work processing unit 13 executes processing relating to the design work, the work processing unit 13 requests the model generation unit 14 to generate a design BIM.

The design screen presents the specification information on the building to the user. The design screen creates a design statement based on the specification information on the building and presents the design statement to the user. Further, the design screen generates a two dimensional CAD drawing based on the specification information on the building, and automatically selects and arranges the facility devices to be installed in the building.

The design screen automatically calculates the amount of greenhouse gas (CO₂) emissions based on the specification information on the building and presents the amount to the user. Further, the design screen calculates the running cost of the building based on the operation BIM and presents the running cost to the user. Thus, the user can efficiently proceed with the design while referring to the greenhouse gas emission amount and the running cost of the building.

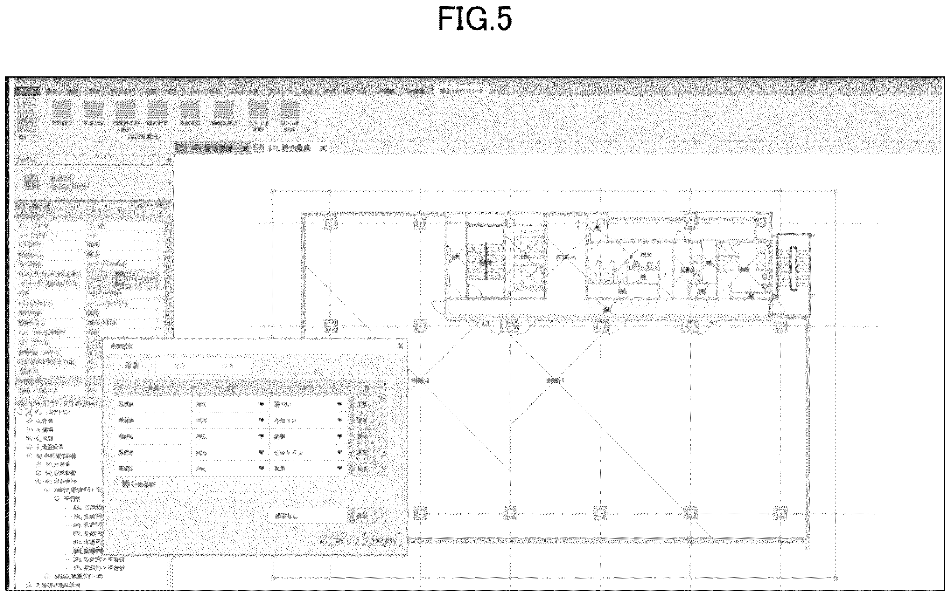

FIGS. 5 to 7 illustrate examples of the design screen. The user executes the design work by operating the design screens as exemplified in FIGS. 5 to 7.

The design screen illustrated in FIG. 5 is used to input various sources of building information. In the design screen, property settings are performed first. In the property settings, outside air conditions, heat sources (cold water temperature, hot water temperature, steam pressure), salt damage countermeasures, structure load (on which side the outer wall is), humidification method, ventilation method, smoke venting method, and the like are set. Next, the system settings are performed. The system settings include the air conditioning system, the air conditioning method (PAC, FCU), the models (concealment, cassette, floor placement, built-in, ceiling-suspended), and the like are set. Then, the use of the rooms is set. The use of settings includes settings of private office rooms, office rooms, conference rooms, lecture halls, cafeterias, lobbies, rest rooms, and the like are set.

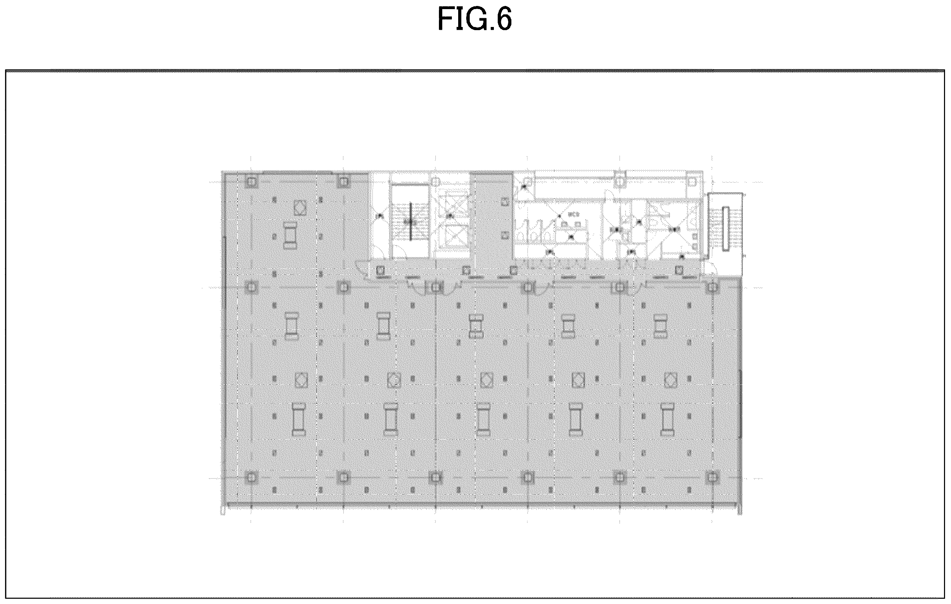

As illustrated in FIG. 6, the settings are automatically made when a range selection is made on the design screen. Note that there is a national standard for cities called the "Chabon" for outside air conditions, and the conditions are set by entering the city. The "Chabon" is the Building Facility Design Standard of the Ministry of Land, Infrastructure, Transport and Tourism, Minister's Secretariat, Government Buildings Department-Facilities.

The model generation unit 14 generates a design BIM, in response to a request from the work processing unit 13. The model generation unit 14 generates a design BIM based on the specification information on the building and the operation BIM.

The model generation unit 14 includes BIM software. The model generation unit 14 generates a BIM model of a building based on a calculation model obtained by structural calculation in advance. The structural calculation is performed using structural calculation software. A BIM model after the structural calculation is created by converting a calculation model (non-BIM model) used for the structural calculation into a BIM model.

The output unit 15 outputs the design BIM generated by the model generation unit 14. The design BIM is transmitted to the initial cost examination system 4 and the construction drawing creation system 5.

### «Functional Configuration of Estimate Support System»

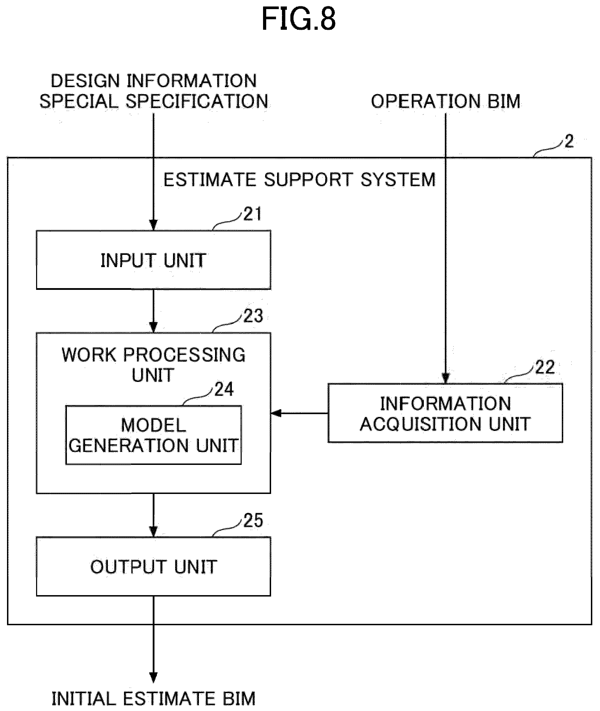

FIG. 8 is a block diagram illustrating an example of a functional configuration of the estimate support system 2 according to the present embodiment. As illustrated in FIG. 8, the estimate support system 2 according to the present embodiment includes an input unit 21, an information acquisition unit 22, a work processing unit 23, a model generation unit 24, and an output unit 25.

The input unit 21, the information acquisition unit 22, the work processing unit 23, the model generation unit 24, and the output unit 25 are implemented by, for example, a process of causing the CPU 501 to execute a program loaded on the RAM 503 from the HDD 504 illustrated in FIG. 2.

The input unit 21 receives inputs of design information and a special specification of a building. The design information on the building is, for example, a two dimensional CAD drawing of a structure and facilities of the building. The input unit 21 receives the design information and the special specification from the user terminal 50, thereby receiving the input of the design information and the special specification. The input unit 21 may scan a paper design drawing and special specification.

The information acquisition unit 22 acquires the operation BIM from the information sharing system 10. The operational BIM is a BIM model relating to a previously constructed building. The operation BIM is generated by the operation management system 9 and stored in the information sharing system 10.

The work processing unit 23 displays an estimate screen for supporting the estimate work on the user terminal 50. The work processing unit 23 executes processing relating to the estimate work, in response to a request from the user terminal 50. When executing the processing relating to the estimate work, the work processing unit 23 requests the model generation unit 24 to generate the initial estimate BIM.

The estimate screen presents a two dimensional CAD drawing to the user. The estimate screen edits the CAD drawing in response to the user's operation. At this time, the estimate screen presents the CAD drawing in a manner that can be compared to previously constructed building designs based on operational BIM. Further, the estimate screen converts the edited two dimensional CAD drawing into a BIM model having no information on height in response to the user's operation, and presents the BIM model to the user.

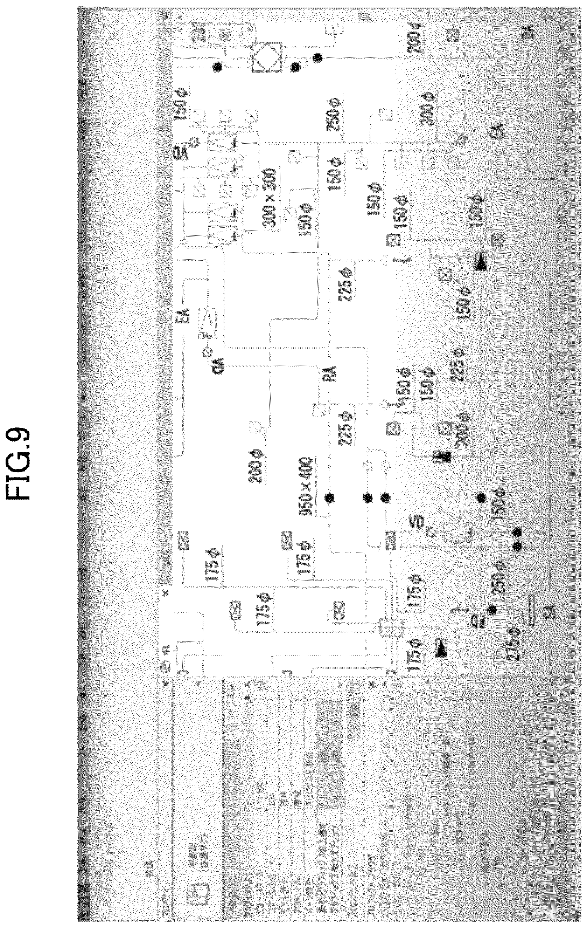

FIGS. 9 to 12 illustrate examples of the estimate screen. The user executes the estimate work by operating the estimate screen as exemplified in FIGS. 9 to 12.

On the estimate screen, line segments on the plan view and symbols connected thereto are recognized and listed. Also, the parts on the list are modeled. It is also possible to switch a plurality of special specifications (standard specifications, specifications for government offices, etc.), collectively change the members on the model, and estimate the necessary materials for each specification.

On the estimate screen, tees, crosses, straight pipes, 90° elbows, dampers, CAVs, and VAVs can be modeled. The modeled tees include a modeled tee with a tee portion made up of shorter orthogonal line segments among orthogonal T-shaped line segments, a modeled tee with a tee portion at the intersection of a long line segment and a line segment orthogonal to the long line segment, and a modeled tee with a tee portion provided with a block of tees made up of orthogonal line segments. The modeled crosses include a modeled cross with a cross portion made up of shorter line segments among intersecting line segments, and a modeled cross with a cross portion at the intersection of long line segments that intersect each other. The modeled 90° elbows include a modeled 90° elbow with an elbow portion made up of orthogonal line segments, a modeled 90° elbow with an elbow portion made up of line segments, and a modeled 90° elbow with an elbow portion provided with a block of 90° elbow.

The model generation unit 24 generates the initial estimate BIM, in response to a request from the work processing unit 23. The model generation unit 24 generates an initial estimate BIM based on the design information on the building, the special specification, and the operation BIM.

The output unit 25 outputs the initial estimate BIM generated by the model generation unit 24. The initial estimate BIM is transmitted to the initial cost examination system 4 and the construction drawing creation system 5.

### «Functional Configuration of Inquiry System»

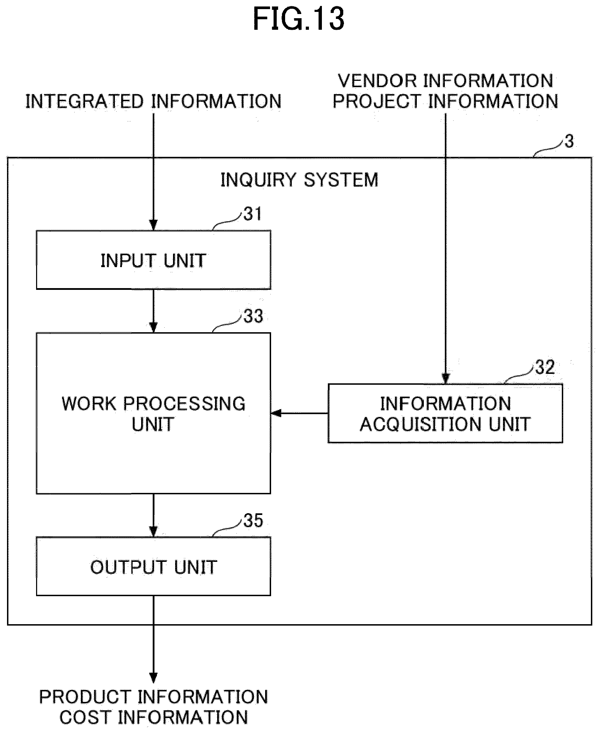

FIG. 13 is a block diagram illustrating an example of a functional configuration of the inquiry system 3 in the present embodiment. As illustrated in FIG. 13, the inquiry system 3 in the present embodiment includes an input unit 31, an information acquisition unit 32, a work processing unit 33, and an output unit 35.

The input unit 31, the information acquisition unit 32, the work processing unit 33, and the output unit 35 are implemented by, for example, a process of causing the CPU 501 to execute a program loaded on the RAM 503 from the HDD 504 illustrated in FIG. 2.

The input unit 31 receives an input of integrated information indicating an initial estimate. The input unit 31 receives the integrated information from the initial cost examination system 4, thereby receiving the input of the integrated information.

The information acquisition unit 32 acquires vendor information and project information. The vendor information is information about device vendors that can perform transactions. The vendor information includes, for example, information indicating contact destinations of the device vendors. The project information is information in which records of previous construction projects are recorded. The project information is, for example, information on the specifications, prices, and the like of the facility devices installed in the building. The information acquisition unit 32 acquires the vendor information and the project information by requesting the vendor information and the project information from the core system 30.

The work processing unit 33 displays an inquiry screen for supporting the inquiry work on the user terminal 50. The work processing unit 33 executes processing relating to the inquiry work, in response to a request from the user terminal 50.

The inquiry screen presents vendor information to the user. The inquiry screen transmits a proposal request to device vendors selected from the vendor information, in response to the user's operation. At this time, the proposal request is described in a unified format on the inquiry screen. Thus, the proposal information received from the device vendor is also described in the unified format.

The inquiry screen presents proposal information received from the device vendors or the like to the user. At this time, the inquiry screen presents the proposal information in a form that can be compared with product information and cost information in previous construction projects. Further, the inquiry screen selects proposal information to be adopted in response to the user's operation. Thus, the product information and the cost information on the facility devices are generated.

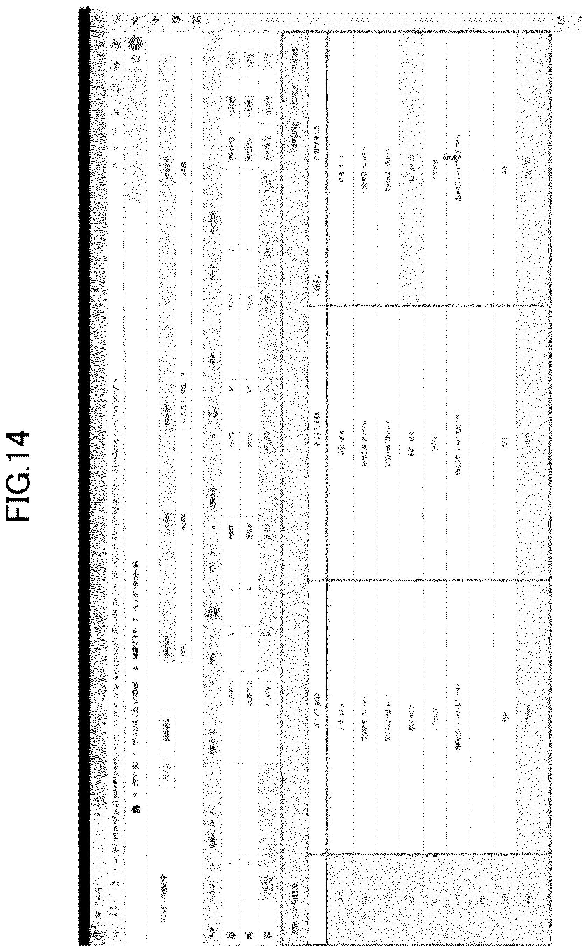

FIG. 14 illustrates an example of the inquiry screen. The user executes the inquiry work by operating the inquiry screen as illustrated in FIG. 14.

The output unit 35 outputs the product information and the cost information generated by the work processing unit 33. The product information and the cost information are transmitted to an initial cost examination system 4.

### «Functional Configuration of Initial cost examination system»

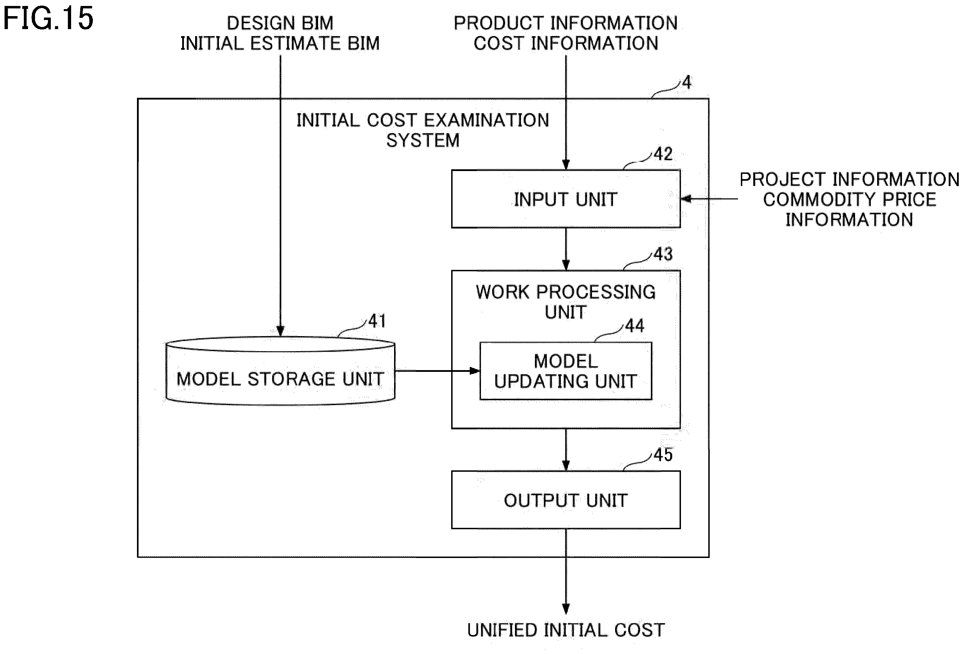

FIG. 15 is a block diagram illustrating an example of a functional configuration of the initial cost examination system 4 in the present embodiment. As illustrated in FIG. 15, the initial cost examination system 4 in the present embodiment includes a model storage unit 41, an input unit 42, a work processing unit 43, a model updating unit 44, and an output unit 45.

The model storage unit 41 is implemented by, for example, the HDD 504 illustrated in FIG. 2. The input unit 42, the work processing unit 43, the model updating unit 44, and the output unit 45 are implemented by, for example, a process of causing the CPU 501 to execute a program loaded on the RAM 503 from the HDD 504 illustrated in FIG. 2.

The model storage unit 41 stores a design BIM and an initial estimate BIM. The design BIM is generated by the automatic design system 1 and transmitted to the initial cost examination system 4. The initial estimate BIM is generated by the estimate support system 2 and transmitted to the initial cost examination system 4.

The input unit 42 receives inputs of product information and cost information. The input unit 42 generates integrated information indicating the initial estimate based on the initial estimate BIM, and transmits the integrated information to the inquiry system 3. The input unit 42 acquires the product information and the cost information by receiving the product information and the cost information from the inquiry system 3.

The input unit 42 acquires commodity price information and project information from the information sharing system 10. The input unit 42 acquires the commodity price information by requesting the commodity price information from the information sharing system 10. The project information is acquired by requesting the project information from the core system 30.

The work processing unit 43 displays an initial cost management screen for supporting the initial cost examination work on the user terminal 50. The work processing unit 43 executes processing relating to the initial cost examination work, in response to a request from the user terminal 50.

The cost management screen presents the product information and the cost information to the user. The cost management screen presents the proposal information in a form that can be compared with the product information and the cost information in previous construction projects. The cost management screen calculates a unified initial cost based on the current commodity price information and presents the unified initial cost to the user. Further, the cost management screen determines the unified initial cost, in response to the user's operation.

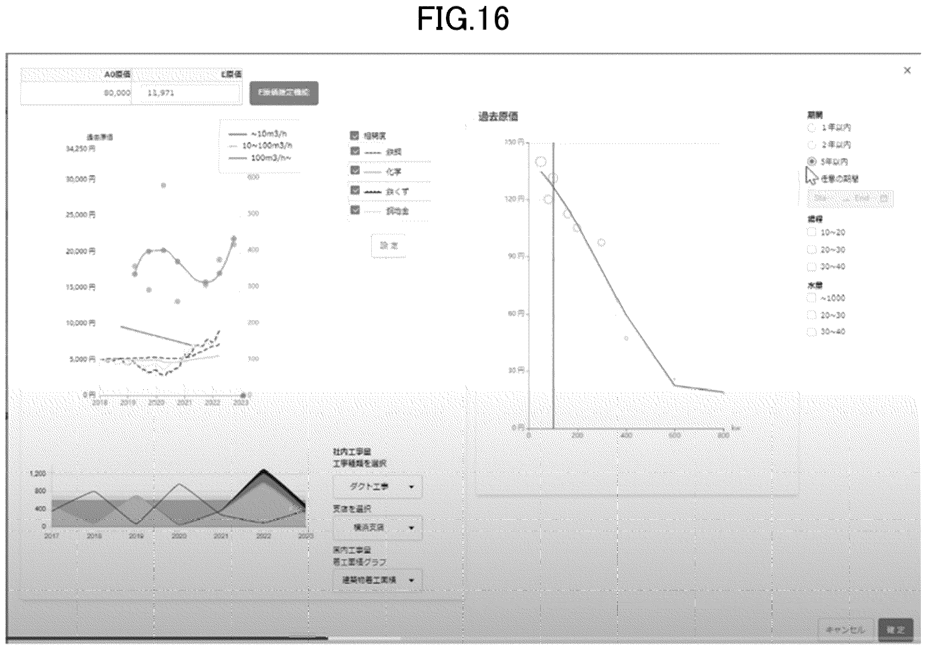

FIG. 16 illustrates an example of the cost management screen. The user executes the initial cost examination work by operating the cost management screen as illustrated in FIG. 16.

The model updating unit 44 updates the initial estimate BIM, in response to a request from the work processing unit 43. The model updating unit 44 updates the initial estimate BIM by registering the product information and the cost information in the attribute information on each object included in the initial estimate BIM.

The model updating unit 44 includes BIM software. The model updating unit 44 creates the updated BIM model by editing the attribute information on each object included in the BIM model before update using the BIM software.

The output unit 45 outputs the unified initial cost, based on the initial estimate BIM updated by the model updating unit 44.

### «Functional Configuration of Construction Drawing Creation System»

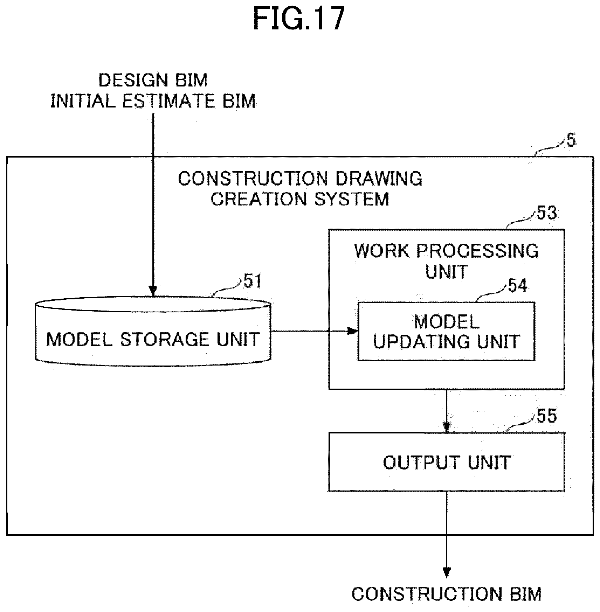

FIG. 17 is a block diagram illustrating an example of a functional configuration of the construction drawing creation system 5 in the present embodiment. As illustrated in FIG. 17, the construction drawing creation system 5 according to the present embodiment includes a model storage unit 51, a work processing unit 53, a model updating unit 54, and an output unit 55.

The model storage unit 51 is implemented by, for example, the HDD 504 illustrated in FIG. 2. The work processing unit 53, the model updating unit 54, and the output unit 55 are implemented by, for example, a process of causing the CPU 501 to execute a program loaded on the RAM 503 from the HDD 504 illustrated in FIG. 2.

The model storage unit 51 stores a design BIM and an initial estimate BIM. The design BIM is generated by the automatic design system 1 and transmitted to the construction drawing creation system 5. The initial estimate BIM is generated by the estimate support system 2 and transmitted to the construction drawing creation system 5.

The work processing unit 53 displays a construction drawing creation screen for supporting the construction drawing creation work on the user terminal 50. The work processing unit 53 executes processing relating to the construction drawing creation work, in response to a request from the user terminal 50. When the work processing unit 53 executes processing relating to the construction drawing creation work, the work processing unit 53 requests the model updating unit 54 to generate the construction BIM.

The construction drawing creation screen generates a two dimensional CAD drawing based on the design BIM and presents the two dimensional CAD drawing to the user. The construction drawing creation screen arranges the facility devices on the two dimensional CAD drawing, in response to the user's operation. Further, the construction drawing creation screen arranges pipes and the like for connecting the facility devices on the two dimensional CAD drawing, in response to the user's operation. At this time, the construction drawing creation screen automatically optimizes the arrangement of the facility devices and the route of the piping.

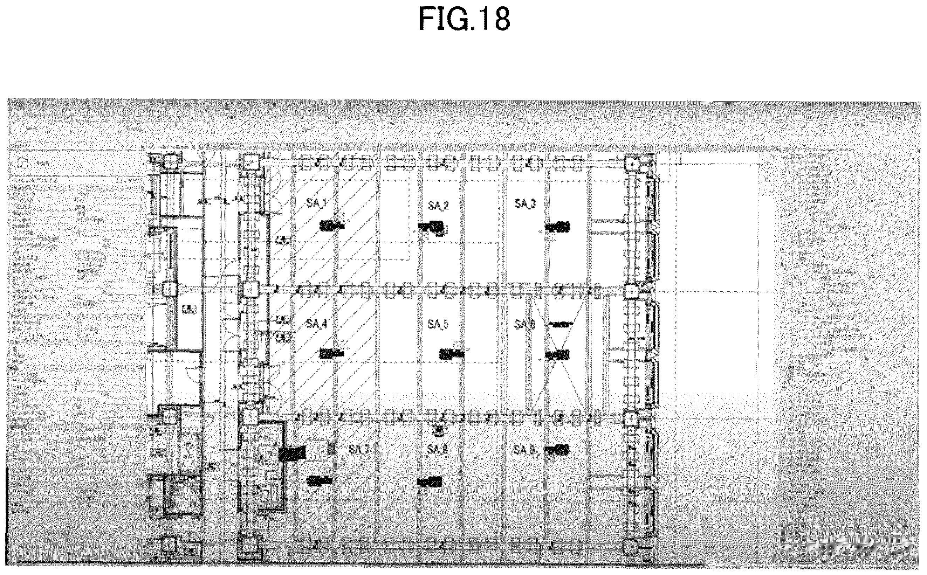

FIGS. 18 to 22 are examples of the construction drawing creation screen. The user executes the construction drawing creation work by operating the construction drawing creation screen as illustrated in FIGS. 18 to 22.

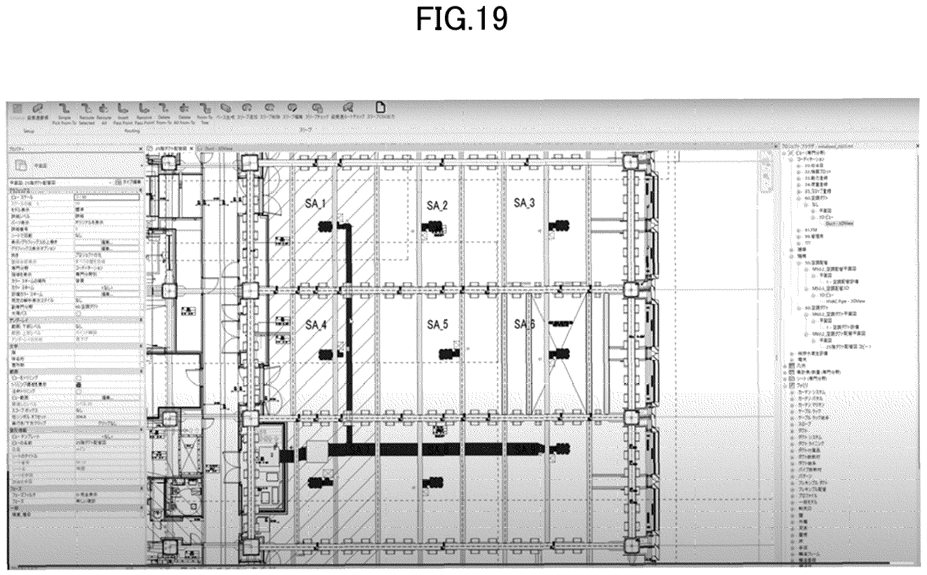

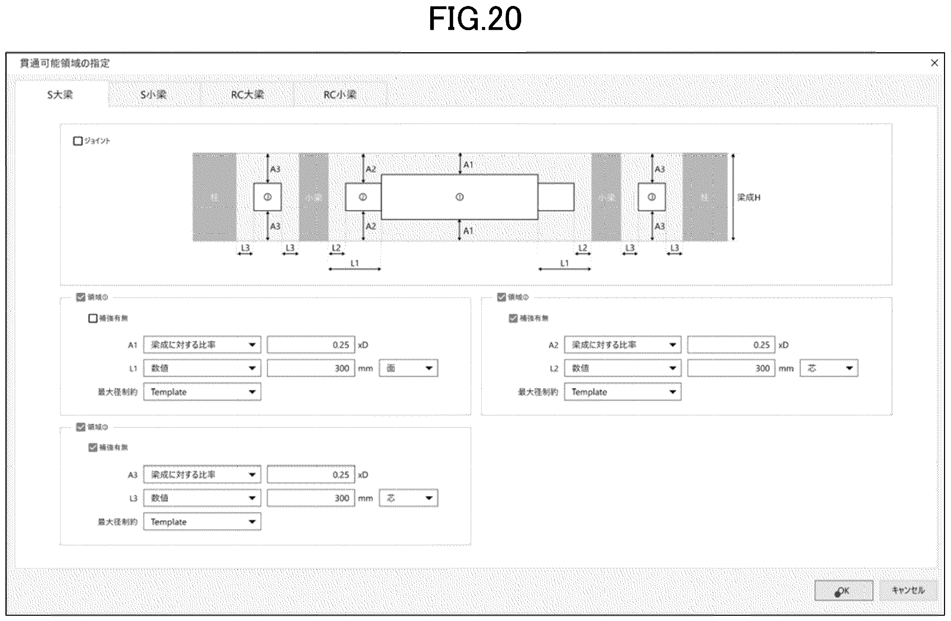

FIGS. 18 and 19 are construction drawing creation screens when performing an automatic duct design. In the automatic duct design, the air outlet of the device and the air outlet SA to the room are clicked to perform automatic creation of the ducts to be connected. FIGS. 20 to 22 are construction drawing creation screens when a sleeve design is performed. In the sleeve design, a position at which a hole is to be formed in the steel frame is automatically designed by designating a steel frame (beam) of a structural skeleton.

The model updating unit 54 generates new design BIM and initial estimate BIM from the two dimensional CAD drawing edited on the construction drawing creation screen, in response to a request from the work processing unit 53, and integrates the design BIM and the initial estimate BIM. Thus, the construction BIM is generated.

The output unit 55 outputs the construction BIM generated by the model updating unit 54. The construction BIM is transmitted to the process management system 6 and the centralized production system 40. The centralized production system 40 manages the order status, delivery date information, and the like of materials, facility devices, and the like used for construction of the building based on the construction BIM, and generates schedule information.

### «Functional Configuration of Process Management System»

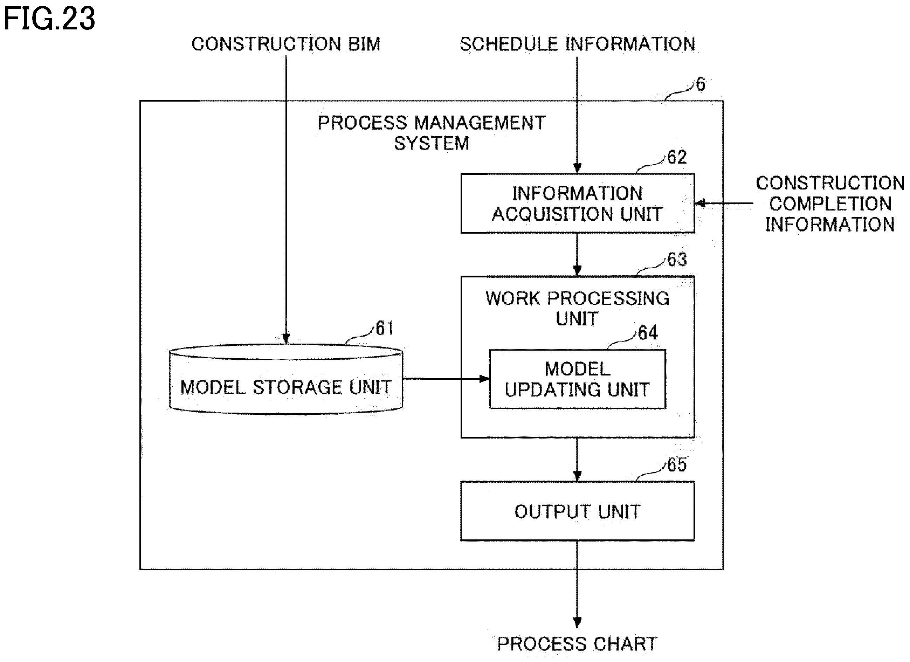

FIG. 23 is a block diagram illustrating an example of a functional configuration of the process management system 6 in the present embodiment. As illustrated in FIG. 23, the process management system 6 in the present embodiment includes a model storage unit 61, an information acquisition unit 62, a work processing unit 63, a model updating unit 64, and an output unit 65.

The model storage unit 61 is implemented by, for example, the HDD 504 illustrated in FIG. 2. The information acquisition unit 62, the work processing unit 63, the model updating unit 64, and the output unit 65 are implemented by, for example, a process of causing the CPU 501 to execute a program loaded on the RAM 503 from the HDD 504 illustrated in FIG. 2.

The construction BIM is stored in the model storage unit 61. The construction BIM is generated by the construction drawing creation system 5 and transmitted to the process management system 6.

The information acquisition unit 62 acquires schedule information. The schedule information is information indicating the order status, delivery date information, and the like of materials, facility devices, and the like used for construction. The schedule information may include schedules, labor productivity per unit, human resources, temporary plans, etc., created by affiliates participating in the construction project. The information acquisition unit 62 acquires the schedule information by requesting the schedule information from the centralized production system 40.

The information acquisition unit 62 receives an input of construction completion information indicating a construction part where construction has been completed. The construction completion information is transmitted from the quality control system 8 when there is a construction part where construction has been completed.

The work processing unit 63 displays a process management screen for supporting the process management work on the user terminal 50. The work processing unit 63 executes processing relating to the process management work, in response to a request from the user terminal 50. When the work processing unit 63 executes the processing relating to the process management work, the work processing unit 63 requests the model updating unit 64 to update the construction BIM.

The process management screen generates a process chart indicating each process of the construction project based on the construction BIM and the schedule information and presents the process chart to the user. At this time, the process management screen determines each process by the number of man-hours corresponding to each object included in the construction BIM.

In addition, the process management screen may generate and present to the user a temporary construction plan, picture process, delivery process, task list, etc., along with the process chart. The process management screen may calculate a progress rate of each process and display the progress rate together with the process chart. At this time, the process management screen may calculate the budget consumption rate together with the progress rate and display the budget consumption rate together with the process chart.

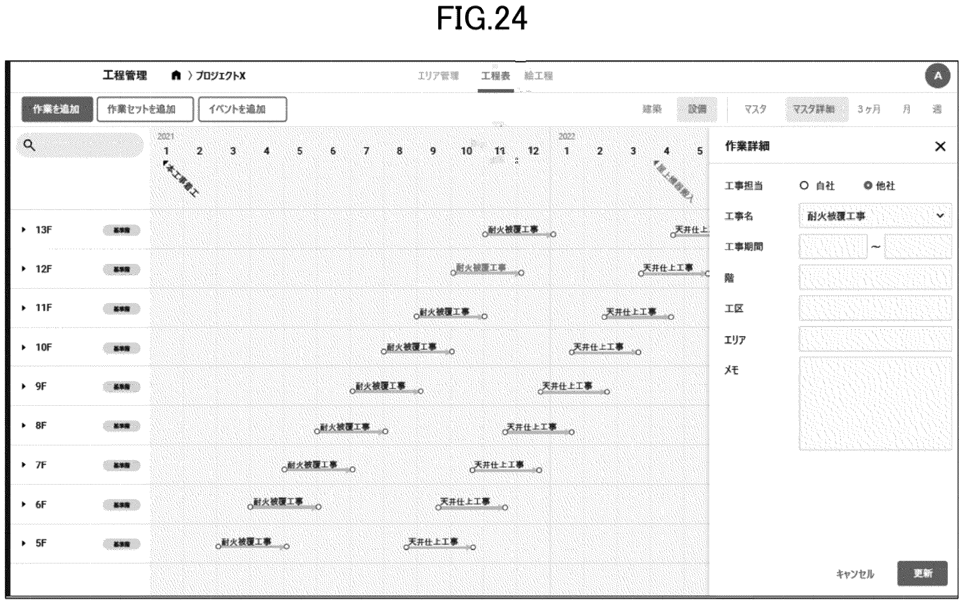

FIG. 24 illustrates an example of the process management screen. The user executes the process management work by operating the process management screen as illustrated in FIG. 24.

The model updating unit 64 updates the construction BIM, in response to a request from the work processing unit 63. The model updating unit 64 updates the construction BIM by registering attribute information indicating the process in the attribute information on each object included in the construction BIM. When the construction completion information is received, the model updating unit 64 registers the construction completion information in the attribute information on each object included in the construction BIM.

The output unit 65 outputs a document such as a process chart based on the construction BIM updated by the model updating unit 64.

### «Functional Configuration of Progress Management System»

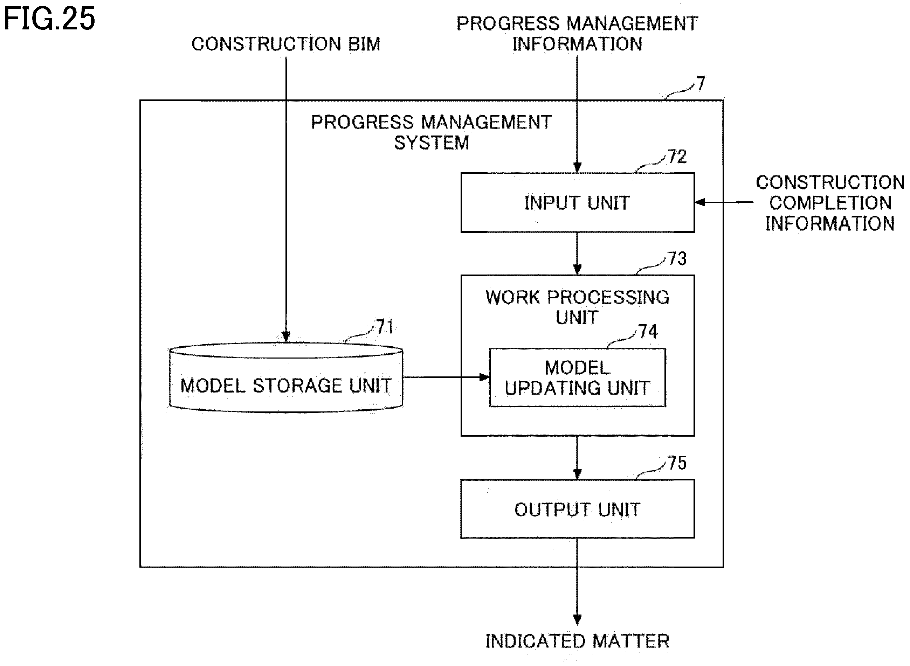

FIG. 25 is a block diagram illustrating an example of a functional configuration of the progress management system 7 in the present embodiment. As illustrated in FIG. 25, the progress management system 7 according to the present embodiment includes a model storage unit 71, an input unit 72, a work processing unit 73, a model updating unit 74, and an output unit 75.

The model storage unit 71 is implemented by, for example, the HDD 504 illustrated in FIG. 2. The input unit 72, the work processing unit 73, the model updating unit 74, and the output unit 75 are implemented by, for example, a process of causing the CPU 501 to execute a program loaded on the RAM 503 from the HDD 504 illustrated in FIG. 2.

The construction BIM is stored in the model storage unit 71. The construction BIM is updated by the process management system 6 and transmitted to the progress management system 7.

The input unit 72 receives an input of progress management information. The progress management information includes identification information for identifying a panoramic photograph (360-degree image) taken in the building and indicated matter. The input unit 72 receives progress management information from the user terminal 50 to receive the input of the progress management information.

The panoramic photograph (360-degree image) may be captured by, for example, a worker wearing an omnidirectional image capturing apparatus moving on the construction site. Alternatively, for example, the panoramic photograph may be performed by flying a small unmanned aerial vehicle (drone) equipped with the omnidirectional image capturing apparatus within the construction site.

The input unit 72 receives an input of construction completion information indicating a construction part where construction has been completed. The construction completion information is transmitted from the quality control system 8 when there is a construction part where construction has been completed.

The work processing unit 73 displays a progress management screen for supporting the progress management work on the user terminal 50. The work processing unit 73 executes processing relating to the progress management work, in response to a request from the user terminal 50. When the work processing unit 73 executes the processing relating to the progress management work, the work processing unit 73 requests the model updating unit 74 to update the construction BIM.

The progress management screen presents the progress status to the user based on the construction BIM and the progress management information. For example, the progress management screen may display the progress status of each object on the construction drawing in different colors. The progress management screen may display an icon near the object for which indicated matter is registered. Further, the progress management screen may be configured to register indicated matter relating to the progress in response to a user's operation.

Further, the progress management screen may display the three dimensional construction drawing on which the progress status is displayed and the panoramic photograph captured at the same place in a comparable manner. At this time, the progress management screen may be configured to be able to enlarge or reduce the three dimensional construction drawing. The progress management screen may be movable to any position on the three dimensional construction drawing in response to a user's operation. When the display is switched (enlarged, reduced, moved, or the like) on the three dimensional construction drawing in response to the user's operation, the progress management screen may automatically switch the display of the panoramic photograph.

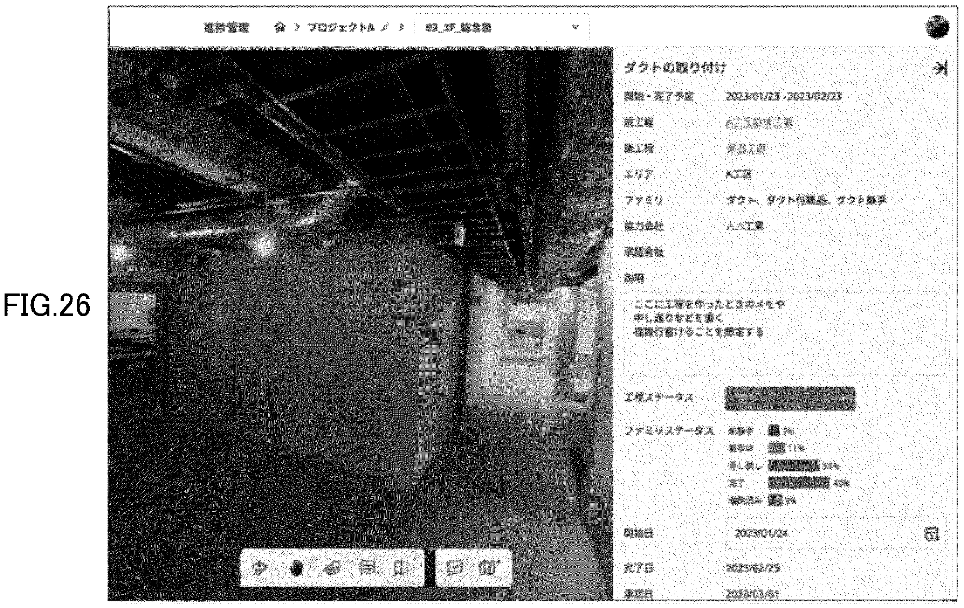

FIGS. 26 to 28 illustrate examples of the progress management screen. The user executes the progress management work by operating the progress management screen as exemplified in FIGS. 26 to 28.

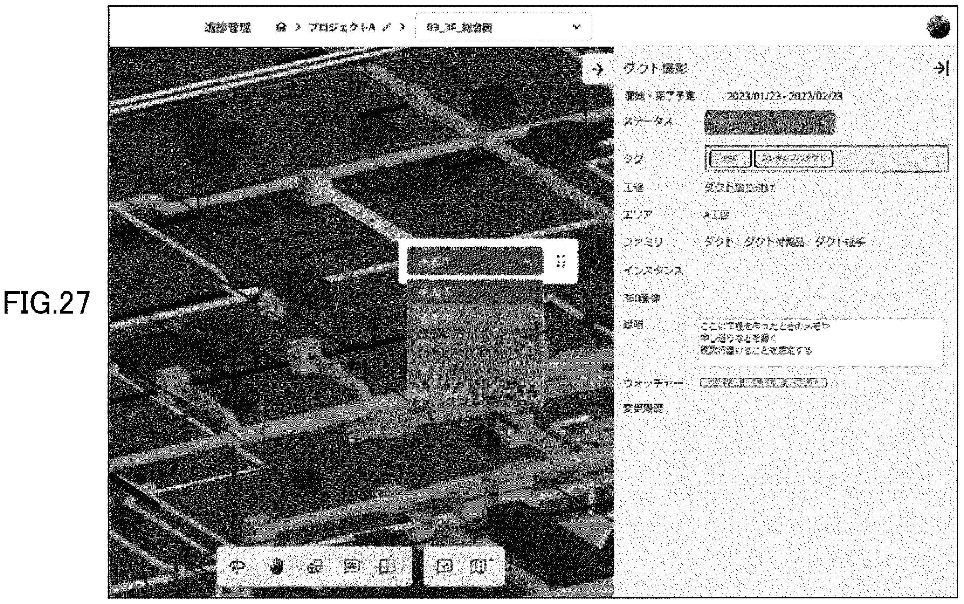

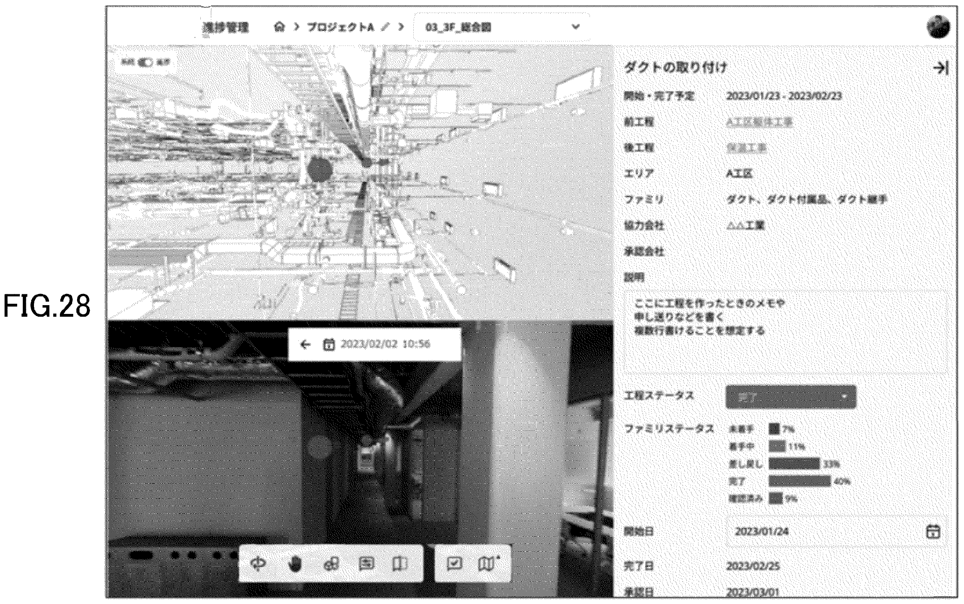

FIG. 26 illustrates a progress management screen when a panoramic photograph is displayed. FIG. 27 is a progress management screen when registering the progress status on the construction drawing. FIG. 28 is a progress management screen when the construction drawing and the panoramic photograph are displayed.

The model updating unit 74 updates the construction BIM, in response to a request from the work processing unit 73. The model updating unit 74 updates the construction BIM by registering the progress management information in the attribute information on each object included in the construction BIM. In addition, when the construction completion information is received, the model updating unit 74 registers the construction completion information in the attribute information on each object included in the construction BIM.

The output unit 75 outputs the indicated matter and the like, based on the construction BIM updated by the model updating unit 74.

### «Functional Configuration of Quality control system»

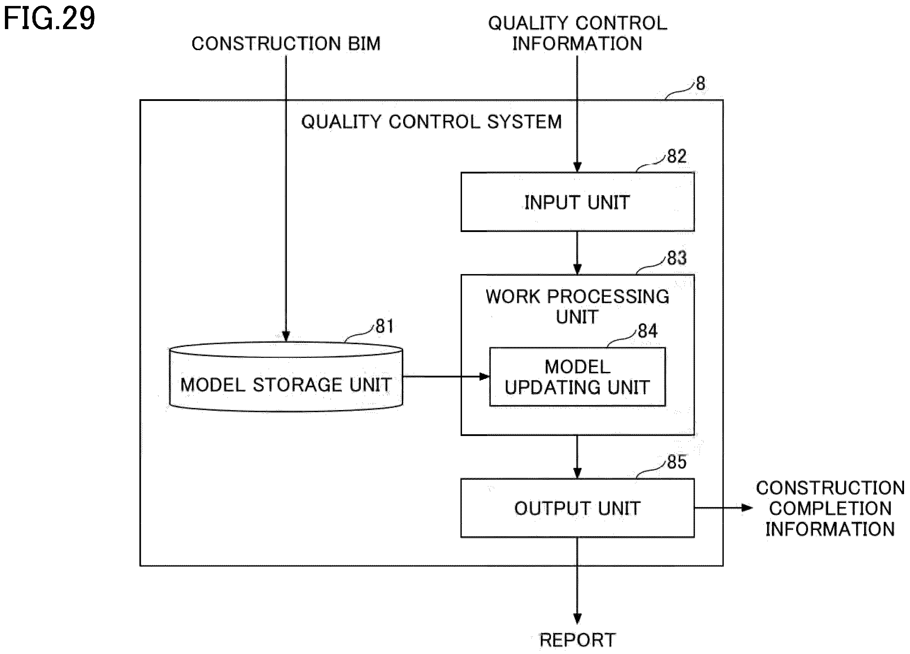

FIG. 29 is a block diagram illustrating an example of a functional configuration of the quality control system 8 in the present embodiment. As illustrated in FIG. 29, the quality control system 8 in the present embodiment includes a model storage unit 81, an input unit 82, a work processing unit 83, a model updating unit 84, and an output unit 85.

The model storage unit 81 is implemented by, for example, the HDD 504 illustrated in FIG. 2. The input unit 82, the work processing unit 83, the model updating unit 84, and the output unit 85 are implemented by, for example, a process of causing the CPU 501 to execute a program loaded on the RAM 503 from the HDD 504 illustrated in FIG. 2.

The construction BIM is stored in the model storage unit 81. The construction BIM is updated by the progress management system 7 and transmitted to the quality control system 8.

The input unit 82 receives an input of quality control information. The quality control information includes a construction photograph taken at the construction site, blackboard information, an inspection list, and the like. The input unit 82 may receive an input of a panoramic photograph and generate progress management information. The input unit 82 receives quality control information from the user terminal 50 to receive the input of the quality control information.

The construction photograph is, for example, an image of the construction site taken after the work by a worker involved in the construction. Further, for example, the construction site after the work captured in the panoramic photograph included in the progress management information may be cut out and used as the construction photograph.

Information other than the photograph data can be shared. When sharing image data such as the inside of a wall surface, the roof space, and the like for progress management in operation management (maintenance management), the data is shared based on the location and orientation that are stored in association with the BIM model. Further, management information (inspection date and time) for quality control is also shared based on the location and orientation that are stored in association with the BIM model.

The work processing unit 83 displays a quality control screen for supporting quality control work on the user terminal 50. The work processing unit 83 executes processing relating to quality control work, in response to a request from the user terminal 50. When the work processing unit 83 executes the processing relating to the quality control work, the work processing unit 83 requests the model updating unit 84 to update the construction BIM.

The quality control screen presents a construction state to the user, based on the construction BIM and the quality control information. For example, the quality control screen may set inspection points on the construction drawing, and may display the progress management information (e.g., the indicated matter) and the quality control information (e.g., the construction photograph and the blackboard information) in association with each inspection point. At this time, a panoramic photograph before construction captured at the inspection point may be further displayed in association with the inspection point. That is, the quality control screen may extract the panoramic photograph from the progress management information registered in the attribute information on the object corresponding to the inspection point and display the construction photograph and the blackboard information in a comparable manner with respect to the panoramic photograph.

The quality control screen outputs various reports, in response to the user's operation. The reports may include, for example, a test operation report, a measurement report, a construction completion report including as-built drawings and photographs, or the like. At this time, the quality control screen outputs a report in a format corresponding to each object included in the construction BIM. Since the construction BIM includes panoramic and construction photographs, for example, a report with before and after photographs of each inspection point can be output.

In addition, the quality control screen may output a memo describing precautions or indicated matter at the construction site. This information can be used to communicate to workers at the construction site who do not have access to the user terminals 50, or as educational material for inexperienced people at the construction site.

The quality control screen may output an inspection list in a format appropriate for each object contained within the construction BIM. The inspection list is information that lists the points to be inspected for the object, and allows the manager or the like at the construction site to efficiently conduct inspections using the to-be-filled inspection list.

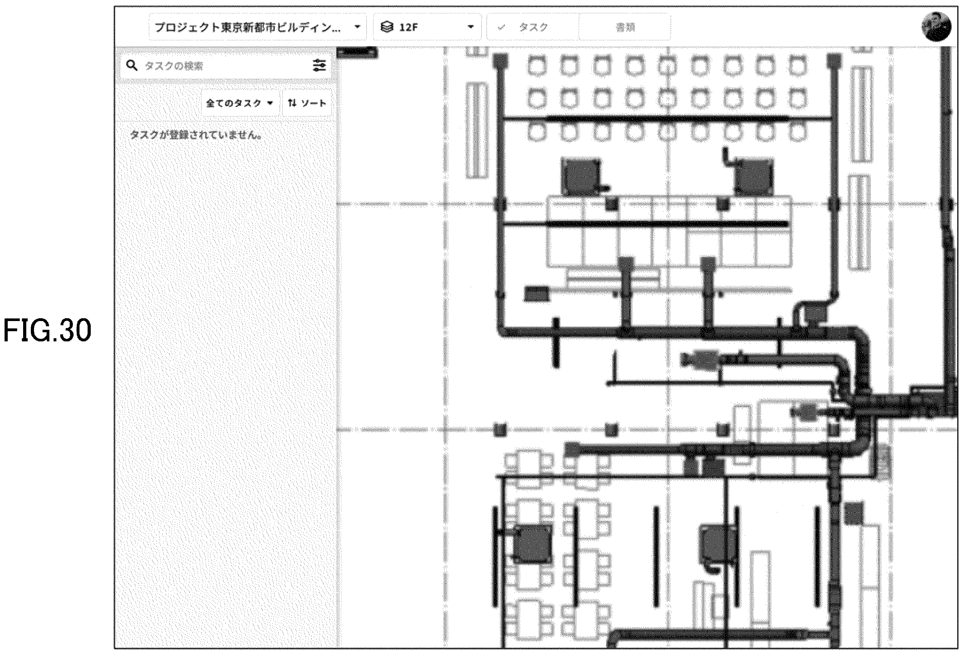

FIGS. 30 to 32 illustrate examples of the quality control screen. The user executes the quality control work by operating the quality control screen as exemplified in FIGS. 30 to 32.

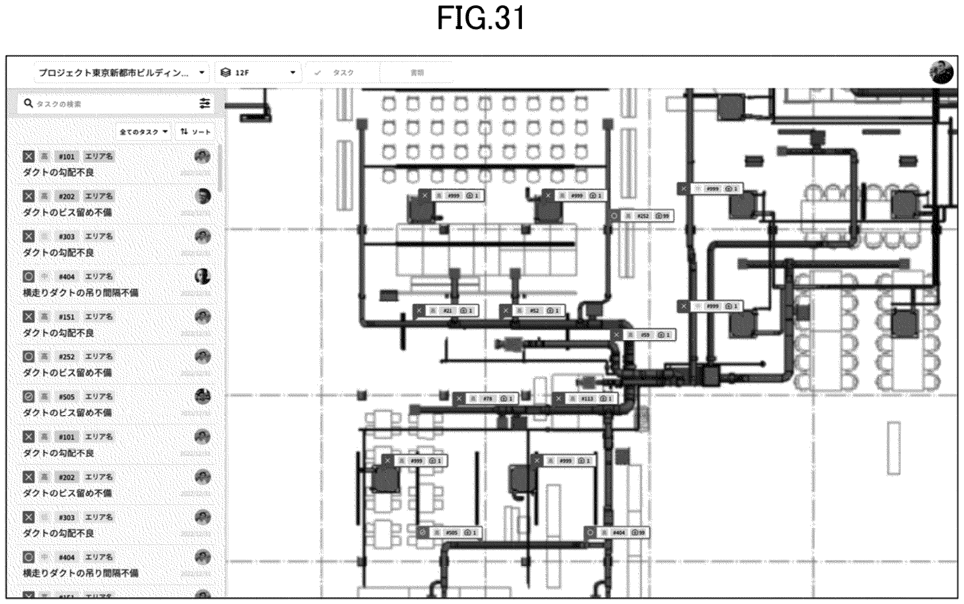

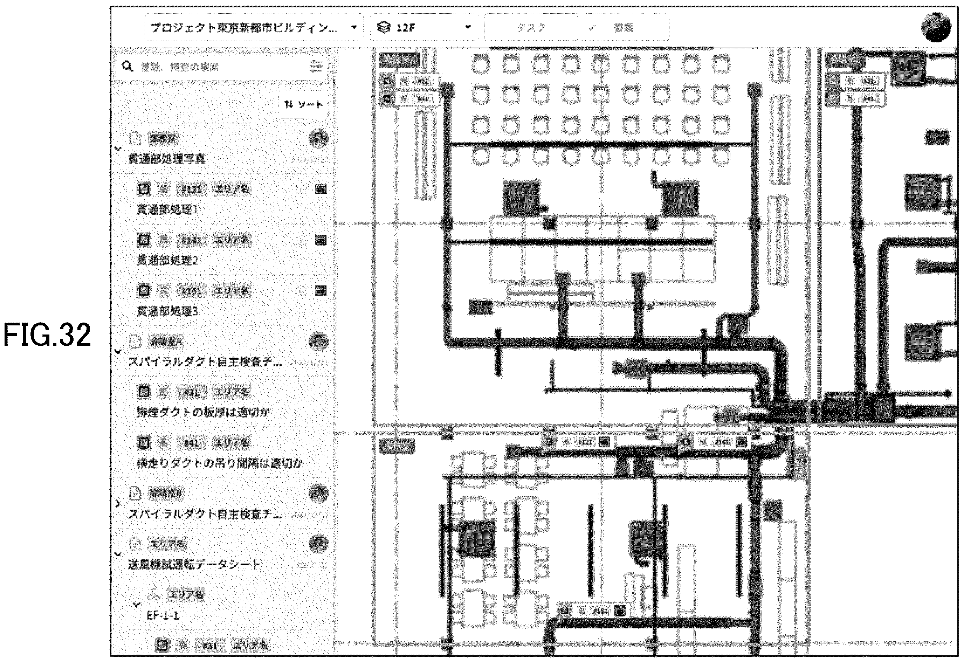

FIG. 30 illustrates a quality control screen when a correction instruction is given. FIG. 31 is a quality control screen when a correction instruction is displayed. FIG. 32 is a quality control screen when displaying the construction photograph ledger.

The model updating unit 84 updates the construction BIM, in response to a request from the work processing unit 83. The model updating unit 84 updates the construction BIM by registering the quality control information in the attribute information on each object included in the construction BIM. When there is a construction part where construction has been completed, the model updating unit 84 registers construction completion information in the attribute information on each object included in the construction BIM.

The output unit 85 outputs construction completion information when there is a construction part where construction has been completed. The construction completion information is transmitted to the process management system 6 and the progress management system 7. The output unit 85 outputs a report or the like based on the construction BIM updated by the model updating unit 84.

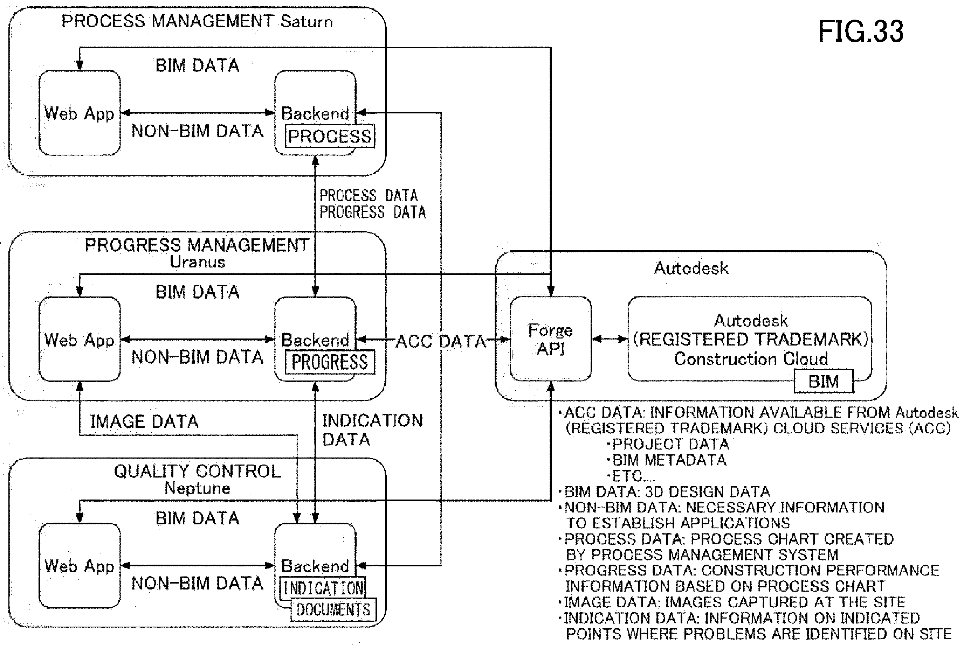

FIG. 33 is a diagram illustrating an example of collaboration among the process management system 6, the progress management system 7, and the quality control system 8. Photograph data and indication data are linked between the progress management system 7 and the quality control system 8. Progress data and process data are linked between the process management system 6 and the progress management system 7. The indication data is linked between the process management system 6 and the quality control system 8.

The BIM may be exchanged between the systems by using software or may be stored in a cloud storage and shared between the systems. Each system specifies the location, orientation, time, and other parameters of the data to be linked based on a common BIM model.

However, the BIM data is not updated and linked to other applications between the process management system 6, the progress management system 7, and the quality control system 8. For example, the process information (information is stored in a DB in the system separately from the BIM data, although there is information linking the information to the BIM data) managed in the process management system 6 may be linked to the progress management system 7 and the quality control system 8.

Further, the 360-degree image in the progress management system 7 can be cut and used when the quality control system 8 creates the indication data. The indication status may be displayed on the dashboard of the progress management system 7.

### «Functional Configuration of Operation Management System»

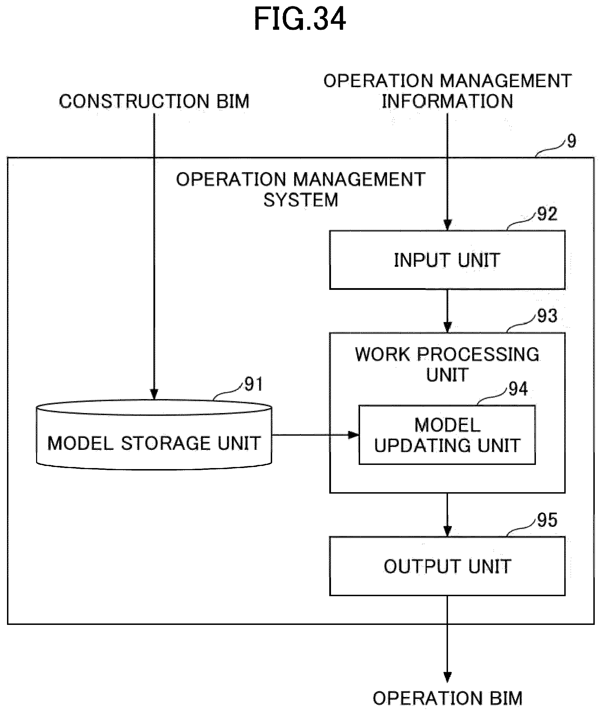

FIG. 34 is a block diagram illustrating an example of a functional configuration of the operation management system 9 in the present embodiment. As illustrated in FIG. 34, the operation management system 9 in the present embodiment includes a model storage unit 91, an input unit 92, a work processing unit 93, a model updating unit 94, and an output unit 95.

The model storage unit 91 is implemented by, for example, the HDD 504 illustrated in FIG. 2. The input unit 92, the work processing unit 93, the model updating unit 94, and the output unit 95 are implemented by, for example, a process of causing the CPU 501 to execute a program loaded on the RAM 503 from the HDD 504 illustrated in FIG. 2.

The model storage unit 91 stores an operation BIM. The operation BIM is a BIM model in which the operation management system 9 registers operation management information for the construction BIM updated by the quality control system 8.

The input unit 92 receives an input of operation management information. The operation management information includes operation data, inspection data, maintenance data, and the like. The input unit 92 receives the operation management information from the user terminal 50 to receive the input of the operation management information.

The work processing unit 93 displays an operation management screen for supporting the operation management work on the user terminal 50. The work processing unit 93 executes processing relating to the operation management work, in response to a request from the user terminal 50. When the work processing unit 93 executes the processing relating to the operation management work, the work processing unit 93 requests the model updating unit 94 to update the operation BIM.

The model updating unit 94 updates the operation BIM, in response to a request from the work processing unit 93. The model updating unit 94 updates the operation BIM by registering the operation management information in the attribute information on each object included in the operation BIM. Therefore, the operation BIM stores a history of operation data, inspection data, maintenance data, and the like relating to the building in operation.

The output unit 95 outputs the operation BIM generated by the model updating unit 94. The operation BIM is transmitted to the information sharing system 10.

### «Functional Configuration of Information Sharing System»

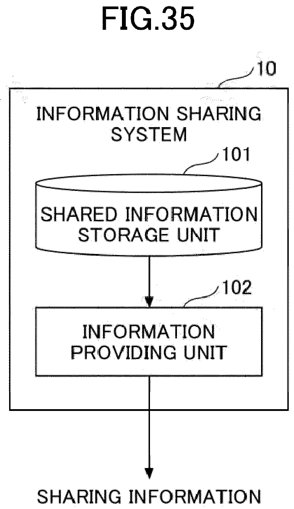

FIG. 35 is a block diagram illustrating an example of a functional configuration of the information sharing system 10 according to the present embodiment. As illustrated in FIG. 35, the information sharing system 10 in the present embodiment includes a shared information storage unit 101 and an information providing unit 102.

The shared information storage unit 101 is implemented by using, for example, the HDD 504 illustrated in FIG. 2. The information providing unit 102 is implemented by, for example, a process of causing the CPU 501 to execute a program loaded on the RAM 503 from the HDD 504 illustrated in FIG. 2.

The shared information storage unit 101 stores in advance shared information that is shared among the work support systems included in the collaborative work support system 100. The shared information includes the operation BIM and the external information. The external information includes previous and current commodity price information (material prices, labor costs, etc.), previous and current climate information, and the like.

The information providing unit 102 receives a request for acquiring shared information from the work support system. The information providing unit 102 reads the shared information indicated by the acquisition request from the shared information storage unit 101. The information providing unit 102 transmits the read shared information to the work support system that has transmitted the acquisition request.

### <Processing Procedure of Collaborative work Support Method>

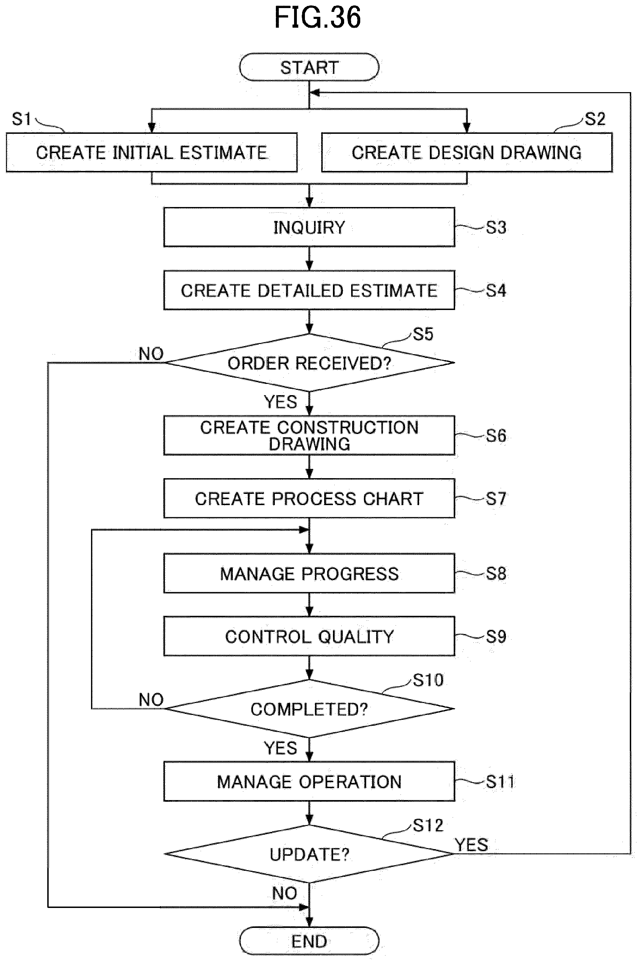

A collaborative work support method executed by the collaborative work support system 100 according to the present embodiment will be described with reference to FIG. 36. FIG. 36 is a flowchart illustrating an example of a collaborative work support method according to the present embodiment.

In step S1, the estimate support system 2 executes estimate support work processing, in response to a request from the user terminal 50. Specifically, first, the estimate support system 2 receives the design information and the special specification of the building from the user terminal 50. Next, the estimate support system 2 generates an initial estimate BIM based on the operation BIM, the design information on the building, and the special specification. The estimate support system 2 transmits the initial estimate BIM to the initial cost examination system 4 and the construction drawing creation system 5.

In step S2, the automatic design system 1 executes design work processing, in response to a request from the user terminal 50. Specifically, first, the automatic design system 1 receives the specification information on the building from the user terminal 50. Next, the automatic design system 1 generates a design BIM based on an operation BIM and the specification information on the building. Then, the automatic design system 1 transmits the design BIM to the initial cost examination system 4 and the construction drawing creation system 5.

In step S3, the inquiry system 3 executes inquiry work processing, in response to a request from the user terminal 50. Specifically, first, the initial cost examination system 4 receives the initial estimate BIM from the estimate support system 2. Next, the initial cost examination system 4 generates integrated information based on the initial estimate BIM and transmits the integrated information to the inquiry system 3.

The inquiry system 3 receives the integrated information from the initial cost examination system 4. Next, the inquiry system 3 receives vendor information and project information from the core system 30. Subsequently, the inquiry system 3 transmits a proposal request including the integrated information to device vendors or the like. Next, the inquiry system 3 receives proposal information from the device vendors or the like. Then, the inquiry system 3 generates product information and cost information based on the proposal information. The inquiry system 3 transmits the product information and the cost information to the initial cost examination system 4.

In step S4, the initial cost examination system 4 executes initial cost examination work processing, in response to a request from the user terminal 50. Specifically, first, the initial cost examination system 4 receives the product information and the cost information from the inquiry system 3. Next, the initial cost examination system 4 calculates a unified initial cost from the product information and the cost information in collaboration with the estimate system 20.

In step S5, the collaborative work support system 100 determines whether or not an order for the detailed estimate created up to step S4 has been received. When the order has been received (YES), the collaborative work support system 100 advances the processing to step S6. When the order has not been received (NO), the collaborative work support system 100 ends the processing.

In step S6, the construction drawing creation system 5 executes construction drawing creation work processing, in response to a request from the user terminal 50. Specifically, first, the construction drawing creation system 5 receives the design BIM from the automatic design system 1. The construction drawing creation system 5 receives the initial estimate BIM from the estimate support system 2. Next, the construction drawing creation system 5 generates a construction BIM based on the design BIM and the initial estimate BIM. Subsequently, the construction drawing creation system 5 transmits the construction BIM to the process management system 6.

In step S7, the process management system 6 executes process management work processing, in response to a request from the user terminal 50. Specifically, first, the process management system 6 receives a construction BIM from the construction drawing creation system 5. The process management system 6 receives schedule information from the centralized production system 40. Next, the process management system 6 updates and generates the construction BIM based on the construction BIM and the schedule information. Subsequently, the process management system 6 transmits the construction BIM to the progress management system 7.

In step S8, the progress management system 7 executes the progress management work processing, in response to a request from the user terminal 50. Specifically, first, the progress management system 7 receives the construction BIM from the process management system 6. Next, the progress management system 7 receives progress management information from the user terminal 50. Subsequently, the progress management system 7 registers the progress management information in the construction BIM. Subsequently, the progress management system 7 transmits the construction BIM to the quality control system 8.

In step S9, the quality control system 8 executes quality control work processing, in response to a request from the user terminal 50. Specifically, first, the quality control system 8 receives the construction BIM from the progress management system 7. The quality control system 8 receives the quality control information from the user terminal 50. Next, the quality control system 8 registers the quality control information in the construction BIM. Subsequently, the quality control system 8 transmits construction completion information to the process management system 6 and the progress management system 7, when the construction part has been completed.

When the construction completion information is received from the quality control system 8, the process management system 6 registers the construction completion information in the construction BIM. When the progress management system 7 receives the construction completion information from the quality control system 8, the progress management system 7 registers the construction completion information in the construction BIM.

In step S10, the quality control system 8 determines whether or not the construction has been completed. When the construction has been completed (YES), the quality control system 8 transmits the execution BIM to the operation management system 9, and advances the processing to step S11. When the construction has not been completed (NO), the quality control system 8 returns the processing to step S8.

In step S11, the operation management system 9 executes operation management work processing, in response to a request from the user terminal 50. Specifically, first, the operation management system 9 receives the construction BIM from the quality control system 8. The operation management system 9 receives operation management information from the user terminal 50. Next, the operation management system 9 registers operation management information in the construction BIM. Then, the operation management system 9 transmits the operation BIM to the information sharing system 10. The information sharing system 10 stores the operation BIM in the shared information storage unit 101.

In step S12, the collaborative work support system 100 determines whether or not to update (rebuild or renew) the building in operation. When the building is to be updated (YES), the collaborative work support system 100 returns the processing to step S1 and starts the estimate work relating to the update of the buildings. When the building is not to be updated (NO), the collaborative work support system 100 ends the processing.

### <Effects of Embodiment>

The collaborative work support system 100 according to the present embodiment includes a plurality of work support systems for supporting a predetermined work relating to construction. A first work support system among the plurality of work support systems registers information indicating electronic data in a BIM model. A second work support system among the plurality of work support systems specifies the electronic data based on one or more parameters of the electronic data. For example, the progress management system 7 registers image data indicating a panoramic photograph taken in a building in the construction BIM. The quality control system 8 specifies the registered panoramic photograph at the inspection point based on the construction BIM. That is, in the collaborative work support system 100, the image data registered in the progress management work via the BIM model can be used in the quality control work. Therefore, according to the collaborative work support system 100 in the present embodiment, it is possible to make the work performed during the life cycle of a building more efficient.

The work support system according to the present embodiment displays information indicating the progress of each object and image data in a virtual space of a building generated based on a BIM model in a comparable manner. For example, in the progress management screen displayed by the progress management system 7, the progress of each object is displayed in a different color on the three dimensional construction drawing so as to be compared with a panoramic photograph taken at the same location. Therefore, according to the work support system in the present embodiment, a user can manage the progress while comparing the construction drawing and the site photograph, and thus can efficiently execute the progress management work.

The work support system according to the present embodiment outputs a report including image data in a format corresponding to an object included in a BIM model. For example, in the progress management screen displayed by the quality control system 8, reports such as a trial operation report, a measurement report, and a construction completion report including as-built drawings and photographs are output in a format corresponding to each object included in the construction BIM. Therefore, according to the work support system in the present embodiment, a user can easily check the construction state by the reports, and thus can efficiently execute the quality control work.

### [Supplementary Explanation]

Each function of the above-described embodiments can be implemented by one or more processing circuits. Here, the "processing circuit" in the present specification includes a processor programmed to execute each function by software, such as a central processing unit (CPU) or a graphics processing unit (GPU) implemented by an electronic circuit, and a device such as an application specific integrated circuit (ASIC), a digital signal processor (DSP), a field programmable gate array (FPGA), or a conventional circuit module designed to execute each function described above.

Although the embodiments of the present invention have been described in detail, the present invention is not limited to these embodiments, and various modifications or changes can be made within the scope of the gist of the present invention described in the claims.

### DESCRIPTION OF THE REFERENCE NUMERALS

- 1: automatic design system
- 2: estimate support system
- 3: inquiry system
- 4: initial cost examination system
- 5: construction drawing creation system
- 6: process management system
- 7: progress management system
- 8: quality control system
- 9: operation management system
- 10: information sharing system
- 20: estimate system
- 30: core system
- 40: centralized production system
- 100: collaborative work support system

## Claims

1. A collaborative work support program comprising a plurality of work support programs for supporting a predetermined work relating to construction,
wherein a first work support program and a second work support program among the plurality of work support programs respectively cause a first computer and a second computer to execute work processing based on one BIM (Building Information Modeling) model and store electronic data during the work processing,
wherein the first work support program causes the first computer to output the electronic data to the second computer, and
wherein the second work support program causes the second computer to specify the electronic data based on one or more parameters in the one BIM model of the electronic data input from the first computer.

2. The collaborative work support program according to claim 1, wherein the first work support program causes the first computer to register information indicating the electronic data in a BIM model.

3. The collaborative work support program according to claim 2, wherein the electronic data is image data captured inside a building constructed using the BIM model.

4. The collaborative work support program according to claim 3,
wherein the first work support program causes the first computer to register information indicating progress of construction in each object of the BIM model, and
wherein the second work support program causes the second computer to register information indicating construction quality in each object of the BIM model.

5. The collaborative work support program according to claim 4, wherein the first work support program causes the first computer to display information indicating progress of each object and the image data in a virtual space of the building generated based on the BIM model in a comparable manner.

6. The collaborative work support program according to claim 5, wherein the second work support program causes the second computer to display the image data captured at an inspection point and the information indicating the construction quality at the inspection point set in the virtual space in a comparable manner.

7. The collaborative work support program according to claim 6, wherein the second work support program causes the second computer to output a report including the image data in a format corresponding to the object.

8. A work support program for supporting a predetermined work relating to construction, wherein the work support program
causes a computer to execute each work processing based on one BIM model and store electronic data during the work processing; and
causes the computer to specify the electronic data based on one or more parameters in the one BIM model of the electronic data input from another computer.

9. A collaborative work support system comprising:
a plurality of work support systems for supporting a predetermined work relating to construction,
wherein a first work support system and a second work support system among the plurality of work support systems each include a work processing unit configured to execute work processing based on one BIM model and store electronic data during the corresponding work processing; and
wherein the work processing unit included in the first work support system outputs the electronic data to the second work support system, and
wherein the work processing unit included in the second work support system specifies the electronic data based on one or more parameters in the one BIM model of the electronic data input from the first work support system.

10. A work support system for supporting a predetermined work relating to construction, the work support system comprising:
a storage unit configured to store electronic data while each work processing is executed based on one BIM model; and
a work processing unit configured to specify the electronic data based on one or more parameters in the one BIM model of the electronic data input from another computer.
